# EUROPEAN PATENT SPECIFICATION

(11) **EP 1 543 704 B1**
(45) Date of publication and mention of the grant of the patent: **17.05.2006**
(21) Application number: 03797365.8
(22) Date of filing: 22.08.2003
(51) Int. Cl.: H05K 3/28, C09D 11/10

(54) **PRINTING PROCESS AND SOLDER MASK INK COMPOSITION**
DRUCKPROZESS UND LÖTMASKENFARBSTOFFZUSAMMENSETZUNG
PROCEDE D'IMPRESSION ET COMPOSITION D'ENCRE D'EPARGNE DE SOUDURE

(30) Priority: 20.09.2002 GB 0221893
(43) Date of publication of application: 22.06.2005
(73) Proprietor: FUJIFILM Imaging Colorants Limited, Blackley, Manchester M9 8ZS (GB)
(72) Inventor: HOPPER, Alan, John, Blackley, Manchester M9 8ZS (GB); JAMES, Mark, Robert, Blackley, Manchester M9 8ZS (GB)
(74) Representative: Mayall, John
(86) International application number: PCT/GB2003/003695
(87) International publication number: WO 2004/028225

(56) References cited:
- EP-A- 0 540 203
- EP-A- 1 142 966
- DE-A- 19 842 379
- GB-A- 1 179 398
- US-A- 4 680 368
- US-A- 5 270 368
- US-A- 6 114 406
- US-B1- 6 310 115

## Description

The present invention relates to a process for making Printed Circuit Boards (hereinafter PCB's) wherein the solder mask is applied to a laminate comprising a dielectric substrate having electrically conductive metal circuitry and where the solder mask is applied by ink jet printing of a computer generated solder mask image.

In the conventional manufacture of PCB's a laminate comprising a dielectric substrate having a copper sheet affixed to at least one side is prepared. The copper surface is overlaid with a photo-resist layer which is typically a carboxylic acid containing polyacrylate. A phototool is prepared which is a negative image of the desired copper electrically conductive circuitry and this is typically a silver halide photographic emulsion. The phototool is placed over the photo-resist layer and irradiated with actinic radiation such as UV light. This causes the photo-resist layer which is exposed to the actinic radiation to polymerise and harden thus producing a latent negative image of the desired circuitry in the photo-resist layer. The unexposed areas of the photo-resist layer which has not been exposed to actinic radiation is then removed using mild aqueous alkali to expose the copper surface and this is then removed by chemical etching resulting in a dielectric substrate containing the required copper circuitry covered by polymerised photo-resist. This photo-resist is finally removed to give a dielectric substrate having the required copper electrically conductive circuitry.

PCB's are now complex sandwiches of numerous individual dielectric substrates containing copper electrically conductive circuitry on one or both sides and the circuitry of these individual elements must be electrically joined in a precise manner in forming the final PCB.

This is typically achieved by using a similar process to that used in preparing the copper electrically conductive circuitry by the photo-resist process described above. Thus, the individual elements comprising a dielectric substrate containing the copper electrically conductive circuitry is coated with a solder mask liquid film which is based on acrylates having carboxylic acid groups. This solder mask film is applied in such a manner to cover the copper circuitry and also penetrate between different tracks of the copper circuitry down to the surface of the dielectric substrate itself. A phototool is prepared which is a negative image of those parts of the copper circuitry which it is desired to join. This phototool is typically a silver halide emulsion which is similar to that used in the photo etch resistant preparation of the electrically conductive copper circuitry. The phototool is placed over the solder mask liquid film and irradiated with actinic radiation such as UV light. This causes the acrylate liquid solder mask to polymerise and harden where it is exposed to actinic radiation. The unexposed areas of the solder mask are then removed using dilute aqueous alkali thereby exposing those parts of the electrically conductive copper circuitry which it is desired to electrically join. The retained solder mask is generally further polymerised and hardened by exposure to high temperatures, typically from 120 to 160°C. The exposed copper surface is then coated with a liquid solder paste which is held in place by the cured parts of the solder mask and heated to melt the solder paste.

When the PCB is a sandwich containing two or more dielectric substrates with copper electrically conductive circuitry the separate dielectric substrates are connected together by a dielectric prepeg which is compatible with the substrate.

The solder mask also provides protection against heat, environmental damage and breakdown of the PCB during its life. Consequently, it is common to apply the solder mask also to the outer surface(s) of the PCB.

There are a number of deficiencies inherent in this process using solder masks. It is a multi-stage process involving six discreet stages and requires the separate preparation of a phototool. The liquid solder mask film is applied over the whole surface of the dielectric substrate containing the required electrically conductive circuitry including those areas from which it is subsequently removed. This is wasteful of materials. The phototool is distanced from the solder mask film and because of light diffraction some areas of the liquid solder mask which are not directly beneath the exposed areas of the phototool tend to polymerise and are more difficult to remove by aqueous alkali. This adversely affects the definition and line density of those parts of the copper circuitry it is desired to expose for contact with the solder paste. Furthermore, use of solder mask acrylate polymers which need to be quickly and effectively removed in a relatively short timeframe requires a relatively high carboxylic acid content. This can adversely impact on those parts of the solder mask which are retained for protection of the individual elements of the PCB. A high number of residual carboxylic acid groups can also reduce the electrical sensitivity of the retained parts of the solder mask by conversion to the salt of the carboxylic acid.

There is therefore a clear advantage in eliminating the need for a phototool and developing a process wherein the solder mask is applied directly to selected areas of a dielectric substrate by ink jet printing where the image is computer generated. This reduces the number of processing stages since it is then only necessary to apply the solder mask to the required parts of the dielectric substrate containing the copper circuitry and to polymerise the solder mask. Such a process saves on solder mask materials since it is only applied to those areas it is required to cover. It eliminates flow problems in applying liquid solder mask to the whole of the dielectric substrate containing the copper circuitry where it is often difficult to avoid entrainment of air between adjacent copper tracks which can adversely effect PCB performance and longevity. Since such a process does not involve a phototool which is distanced from the surface of the solder mask there is no actinic radiation diffraction and polymerisation of the solder mark which is not directly below the transparent areas of the phototool. This offers the potential for greater definition and line density of the solder paste. Because the solder mask is only applied to the required areas of the dielectric substrate containing the copper circuitry, it is not necessary to selectively remove the solder mask from undesired areas by aqueous alkali treatment. The solder mask does not, therefore, need to have a high carboxylic acid content which offers the potential for improved electrical resistance of the solder mask.

German patent application No. DE 198 42 379 A1 discloses a process of applying a solder mask onto selected areas of the substrate by ink jet printing. DE 198 42 379 A1 does not disclose the composition of the inks used therein.

European patent application No. EP 0 540 203 A1 discloses a non-conductive ink suitable for use in piezo-electric drop-on-demand systems. EP 0 540 203 A1 does not disclose use of the ink as a soldermask or inks comprising an adhesion promoting organic compound.

According to the present invention there is provided a process for making an electronic device which comprises applying a non-aqueous solder mask ink which is substantially free from organic solvent to a dielectric substrate containing electrically conductive metal circuitry, exposing the solder mask ink to actinic radiation and/or particle beam radiation optionally followed by thermal treatment, whereby the solder mask ink is applied to selected areas of the substrate under the control of a computer by ink jet printing and wherein the solder mask ink comprises the components:
A) 30 - 90 parts acrylate functional monomers which are mono or higher acrylate functional monomers comprising from 5 - 95% by weight of one or more manofunctionat monomers;
B) 0.1 - 30 parts metal adhesion promoting organic compound,
C) 0 - 30 parts initiator;
D) 0 - 10 parts polymer and/or prepolymer;
E) 0 - 5 parts colorant; and
F) 0 - 5 parts surfactant;
wherein all parts are by weight.

As disclosed hereinbefore the solder mask ink is substantially free of organic solvents. By this is meant no additional solvents are required and only traces of solvents may be present as impurities or by-products in the manufacture of the various components used to make the ink. It is preferred that the ink contains riot greater than 2 parts, more preferably not greater than 1 part and especially not greater than 0.5 parts organic solvent based on the total amount of the ink. It is most preferred that the solder mask ink is free from organic solvent.

The required viscosity of the solder mask ink is largely dependant on the particular print head employed and especially its temperature of operation. At present most suitable commercial print heads operate at a temperature from 25°C to 65°C. consequently, it is preferred that the viscosity of the solder mask ink is not greater than 30 cPs (mPa.s) at 40°C. Viscosity can be measured on any suitable equipment but is preferably measured using a Brookfield viscometer with a rotating spindle, for example a number 18 spindle. Preferably the viscosity of the solder mask is not greater than 20 and especially not greater than 15 cPs (mPa.s) at 40°C. It is also preferred that the viscosity is not less than 5 and especially not less than 8 cPs (mPa.s) 40°C. Preferably the viscosity is from 8 to 15 cPs (mPa.s) at 40°C. In one embodiment the number of parts of components A) + B) + C) + D) + E) + F) = 100.

Preferably the ink jet printing is carried out using a Drop-on-Demand (DOD) piezo ink jet printer.

The term acrylate-functional as used hereinbefore means any monomer which contains the residue of a reactive vinyl group such as CH₂=C(R)CO- where R is hydrogen alkyl or cyano. When R is alkyl it is preferably C₁₋₆-alkyl. It is particularly preferred that the acrylate functionality is conferred by a methacryloyl or especially an acryloyl group. The monomers may have a relatively low molecular weight or they may be oligomeric or polymeric in nature and may be of a molecular weight as high as 30,000. They are distinguished from the polymers or prepolymers which is component D) of the ink composition in that they are not polymers or prepolymers derived from the polymerisation of acrylate functional monomers. They may, however, be macromolecular and may contain hydrocarbyl groups linked by one or more heteroatoms as for example in polyethers, polyamides, urethanes, polyesters and ureas. The only limitation on the type and molecular size of the acrylate functional monomers is that they must be compatible, the one with the other, they must not form separate phases in the final solder mask ink, the solder mask ink must have the prescribed viscosity. Typically, the acrylate functional monomers have a weight average molecular weight (Mw) below 30,000, more preferably not greater than 10,000, even more preferably not greater than 5,000 and especially not greater than 2,000 since this helps keep the viscosity of the solder mask ink within the prescribed limits.

Specific examples of acrylate functional monomers are those which are commercially available under the Sartomer™, Actilane™ and Photomer™ trademarks such as Sartomer™ 506 (isobornyl acrylate), Sartomer™ 306 (tripropylene glycol diacrylate), Actilane™ 430 (trimethylol propane ethoxylate triacrylate), Actilane™ 251 (a tri-functional acrylate oligmer), Actilane™ 411 (a CTF acrylate), Photomer™ 4072 (trimethylol propane propoxylate triacrylate), Photomer™ 5429 (a polyester tetra acrylate) and Photomer™ 4039 (a phenol ethoxylate monoacrylate). Sartome™, Actilane™ and Photomer™ are trademarks of Cray Valley Inc, Akros BV and Cognis Inc, respectively. Other examples of monomers are lauryl acrylate, isodecylacrylate, iso-octyl acrylate, butyl acrylate, 2-hydroxy ethyl acrylate, 2-hydroxy propylacrylate, 2-ethyl hexyl acrylate, 1,6-hexanediol diacrylate, neopentyl glycol diacrylate, diethylene glycol diacrylate, butanediol diacrylate, trimethylolpropane triacrylate, pentaerythritol triacrylate, 1,3-butylene glycol diacrylate, 1,4-butylene glycol diacrylate, triethylene glycol diacrylate, pentaerythritol tetra acrylate, tripropylene glycol diacrylate, isobornyl acrylate, 2-norbornyl acrylate, cyclohexyl acrylate, phenoxyethyl acrylate and tetrahydrofurfuryl acrylate.

Preferably the acrylate functional monomer is isobornyl acrylate, tripropylene glycol diacrylate or trimethylol propane ethoxylate triacrylate.

It is preferred that the amount of mono-functional acrylate monomer is 15 - 95%, more preferably 40 - 95%, especially 60 - 95% and more especially 70 - 95% by weight of the total amount of acrylate functional monomers represented by component A).

The adhesion promoting organic compound may be any organic compound which contains a metal chelant group or groups which can form a bond with the metal forming the conductive circuitry of the electrical device and which is compatible with the acrylate functional monomers of component A). This is referred to hereinafter as Adhesion Promoter. The Adhesion Promoter may be monomeric or polymeric in nature and may contain one or more acrylate functional groups as defined hereinbefore. Where the Adhesion Promoter does not react with the acrylate-functional monomers of component A) it is preferably capable of intercolating with the polymeric material formed by component A) after exposure to actinic radiation or particle beam radiation (e.g. electron beam) and optionally thermal treatment. However, it is preferred that the Adhesion Promoter is capable of reacting with the acrylate-functional monomers of component A) either during exposure to actinic radiation or particle beam radiation or during subsequent thermal treatment. Whilst the Adhesion Promoter may contain any group capable of reacting with the acrylate functional monomers of component A), it is very much preferred that the Adhesion Promoter is also acrylate-functional and especially an acrylate-functional monomer, e.g. (meth)acrylic acid.

The metal chelant group of the Adhesion Promoter is any organic moiety which contains a hydrogen atom capable of being displaced by the metal of the electrically conductive circuitry or which possesses a lone pair of electrons capable of forming a bond with the said metal. Examples of such groups are hydroxides, especially aryl or heteroaryl hydroxides such as phenolic hydroxides; amines which may be aliphatic, aryl or heteroaryl; mercaptans which may be aliphatic, aryl or heteroaryl; carboxylic acids which may be aliphatic, aryl or heteroaryl; oximes and ketoximines; acetarylamides; hydroxy silanes and silicones; N-containing heterocyles such as imidazoles, benzimidazoles, triazoles, benztriazoles, thiazoles, isothiazoles and acid anhydrides. Where the Adhesion Promoter contains more than one metal chelant group these may be the same or different. In one preferred class of Adhesion Promoters which contains two chelant groups, the chelant groups are attached to adjacent carbon atoms such as β-diketones, β-keto esters, β-keto aldehydes and β-keto heterocyles.

Preferably the metal chelant group is carboxylic acid. Examples include 2-acrylamido glycolic acid, mono-2-(methacryloyloxy) ethyl phthalate, acrylic acid, methacrylic acid, 2-carboxyethyl acrylate, 2-acetamido acrylic acid, mono-2-(acryloyloxy) ethyl succinate, 2,2-bis(acryloylamino) acetic acid, bis(2-(methacryloylethyl) phosphate, bis-(3-sulphopropyl) itaconic acid, ethylene glycol methacrylate, itaconic acid, mono-2-(methacryloyloxy) ethyl phosphate, mono-2-(methacryloyloxy) ethyl succinate, 2-(sulpho oxy) ethyl methacrylic acid, 2-acrylamido-2-methyl-1-propane sulphonic acid, 3-sulphopropyl acrylic acid, mono-2-(methacryloyloxy) ethyl phthalate, 3-sulphopropyl methacrylic acid, maleic acid, fumeric acid and mono-2-(acryloyloxy) ethyl phthalate. Actilane™ 276 (tetra functional urethane acrylate), Actilane™ 320 HD 20 (difunctional epoxy acrylate), Actilane™ 340 (trifunctional epoxy acrylate), Actilane™ 505 (tetrafunctional polyester acrylate), AAEM (acetoacetoxy ethylmethacrylate), Photomer™ 5929 (polypropylene glycol tetra acrylate), Actilane™ 820 (difunctional acrylate), Actilane™ 872 (difunctional acrylate), Actilane 890 (pentafunctional melamine acrylate), Photomer™ 5004F (silane acrylate), Sartomer™ 3050 (acidic monoacrylate), mono-2-(methacryloyloxy) ethyl succinate, bis(2-methacryloxy)ethylphosphate, Photomer ™ 4703, 2-hydroxy-3-phenoxy propyl acrylate and diurethane dimethacrylate. Actilane™, Photomer™ and Sartomer™ are trade names of Akros BV, Cognis Inc and Cray Valley Inc, respectively. The precise chemical structure of those Adhesion Promoters available under commercial trade names is not known but from the description of the products they are believed to contain hydroxy and/or carboxylic acid groups. Many of these commercially available Adhesion Promoters are derived from diols and polyols which are esterified by reaction with (meth)acrylate acid and consequently they may contain free (meth)acrylic acid. This free (meth)acrylic acid may be the actual Adhesion Promoter. However, for the purpose of the invention commercial mixtures containing free (meth)acrylic acid are to be regarded as single compounds, especially regarding their acid values.

The carboxy containing monomers may exhibit acid values in excess of 300 mg KOH/g such as (meth)acrylic acid. However, it is preferred to use carboxy containing monomers where the acid value is not greater than 120, more preferably not greater than 80 and especially not greater than 30 mg KOH/g.

When the ink jet ink contains a metal adhesion promoting compound which contains a carboxylic acid group it may be preferred to make the ink available in a two-pack composition in order to improve stability under storage. In a preferred two-pack composition, the initiator (component C) and carboxy containing metal adhesion promoting compound (component B) are separated. In a particularly preferred two-pack composition, the initiator is made available in a formulation together with either some or all of the acrylate functional monomers which constitute component (A), especially the mono-functional acrylate monomers.

It is preferred that the amount of metal adhesion promoting organic compound which is component B) in the solder mask ink is not less than 0.25 and especially not less than 0.4 parts. Preferably the amount of metal adhesion promoting organic compound is not greater than 20 parts, more preferably not greater than 15 parts and especially not greater than 10 parts.

After polymerisation of the solder mask ink the solder mask should exhibit high resistance to alkali and have high resistivity. Consequently, it is preferred that the acid value of the total solder mask ink and hence the resultant solder mask is not greater than 30, more preferably not greater than 20 and especially not greater than 10mg KOH/g.

The initiator represented by component C) may be any initiator including optional synergists which are commonly used in the trade to initiate polymerisation of acrylate functional monomers. The initiator and synergist when present are preferably free-radical initiators and may be activated by actinic radiation such as UV radiation or by accelerated particles as, for example, in electron beam radiation. Suitable sources of actinic radiation include mercury lamps, xenon lamps, carbon arc lamps, tungsten filament lamps, lasers, electron beam and sunlight. Ultraviolet (UV) radiation is especially that emitted by medium pressure mercury lamps. Thus the initiator is preferably a photo-initiator.

Examples of suitable initiators and synergists are anthraquinone, substituted anthraquinones such as alkyl and halogen substituted anthraquinones such as 2-tert butyl anthraquinone, 1-chloroanthraquinone, p-chloroanthraquinone, 2-methylanthraquinone, 2-ethylanthraquinone, octamethyl anthraquinone and 2-amylanthraquinone; optionally substituted polynuclear quinones such as 1,4-naphthoquinone, 9,10-phenanthraquinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, 3-chloro-2-methylanthraquinone, retenequinone, 7,8,9,10-tetrahydronapthaacenequinone, 1,2,3,4-tetrahydro benzanthracene-7.2-dione, acetophenones such as acetophenone, 2,2-dimethyoxy-2-phenyl acetophenone, 2,2-diethoxy-2-phenyl acetophenone, 1,1-dichloro acetophenone, 1-hydroxy cyclohexyl-phenylketone and 2-methyl-1-(4 methylthio)phenyl-2-morpholinpropan-1-one; thioxanthones such as 2-methylthioxanthone, 2-decylthioxanthone, 2-dodecylthioxanthone, 2-isopropylthioxanthone, 2,4-dimethylthioxanthone, 2,4-diethylthioxanthone, 2-chlorothioxanthone and 2,4-diisopropylthioxanthone; ketals such as acetophenone dimethylketal and dibenzylketal; benzoins and benzoin alkyl ethers such as benzoin, benzyl benzoin methyl ether, benzoin isopropyl ether and benzoin isobutyl ether; azo compounds such as azobisisovaleronitrile; benzophenones such as benzophenone, methylbenzophenone, 4,4¹-dichlorobenzophenone, 4,4¹-bis-diethylaminobenzophenone, Michler's ketone and xanthones, including mixtures thereof. Important commercial initiators and synergists are Speedcure™ ITX, EHA and 3040, Irgacure™ 184, 369, 907 and 1850 and Daracure™ 1173. Speedcure™, Irgacure™ and Daracure™ are registered trademarks of Lambson Plc and Ciba GmbH, respectively.

The amount of initiator and synergist is preferably not greater than 20 parts and more preferably not greater than 15 parts and especially not greater than 12 parts by weight. It is also preferred that the amount of initiator is not less than 5 parts.

The solder mask ink may be exposed to actinic radiation and/or particle beam radiation at any convenient time after the ink is expressed from an ink jet printing nozzle of a print head and includes in-flight and post-flight exposure of the ink.

The thermal treatment to which the solder mask may be exposed after exposure to actinic or particle beam radiation is preferably carried out at a temperature of from 80°C to 250°C. It is preferred that the temperature is not less than 100°C and especially not less than 120°C. In order to inhibit charring of the solder mask the temperature is preferably not greater than 200°C and especially not greater than 160°C. Thermal treatment is normally carried out for between 15 and 90 minutes. The purpose of the thermal treatment is to increase the polymerisation of the solder mask. This further polymerisation during thermal treatment may be accelerated by including radical initiators which promote thermal curing of polymers such as peroxides and azo compounds. However, the addition of such thermal curing initiators is not generally necessary since the polymeric solder mask normally retains sufficient free radicals following exposure of the solder mask ink to actinic or particle beam radiation.

The metal circuitry of the electronic device may be any metal or alloy which is conventionally used for such devices and includes gold, silver, palladium, nickel/gold, nickel, tin, tin/lead, aluminium, tin/aluminium and especially copper.

The dielectric substrate of the electronic device may be any non-conductive material but it is typically paper/resin composite or a resin/fibre glass composite, ceramic, polyester or polyimide (e.g. Kapton of DuPont Inc).

The polymer or prepolymer which is component D) may be any polymeric material which is compatible with the acrylic functional monomers represented by component A). It is distinguished from the acrylate functional monomers represented by A) in that it is devoid of acrylate functionality and/or is derived from polymerising one or more acrylate functional monomers. The polymer or prepolymer typically has a number average molecular weight of from 500 to about 100,000.

Preferably the molecular weight is not greater than 30,000 and especially not greater than 10,000. It is also preferred that the molecular weight is not less than 700 and especially not less than 2,000. The polymeric material may belong to any class of resin such as polyurethane, polyester, polyimide, polyamide, epoxy, silicone-containing resin or fluorinated resin materials, including mixtures thereof. The prepolymer or polymer may react with one or more of the acrylate functional monomers represented by component A) or it may intercolate with the acrylate polymer formed by polymerising the acrylate monomers represented by component A). It is preferred that the amount of component D) when present is not greater than 10 parts, more preferably not greater than 5 parts and especially not greater than 3 parts by weight. It is especially preferred that the ink is free from component D).

Although the solder mask ink may be colourless it is generally preferred to include a colorant since this more clearly identifies those regions of the electronic device to which the solder mask has been applied.

The colorant which is component E) of the solder mask ink composition is preferably a pigment and may be organic or inorganic including those pigments with surface modification which facilitates self dispersion in the ink. The pigment may be from any of the recognised classes of pigments described, for example, in the Third Edition of the Colour Index (1971) and subsequent revisions of and supplements thereto under the chapter headed "Pigments". Examples of inorganic pigments are titanium dioxide, Prussian blue, cadmium sulphide, iron oxides, vermillion, ultramarine and the chrome pigments, including chromates, molybates and mixed chromates and sulphates of lead, zinc, barium, calcium and mixtures and modifications thereof which are commercially available as greenish-yellow to red pigments under the names primrose, lemon, middle, orange, scarlet and red chromes. Examples of organic pigments are those from the azo, diazo, condensed azo, thioindigo, indanthrone, isoindanthrone, anthanthrone, anthraquinone, isodibenzathrone, triphendioxazine, quinacridone and phthalocyanine series, especially copper phthalocyanine and its nuclear halogenated derivatives, and also lakes of acid, basic and mordant dyes. Carbon black, although strictly inorganic, behaves more like an organic pigment in its dispersing properties. Preferred organic pigments are phthalocyanines, especially copper phthalocyanines, monoazos, diazos, indanthrones, anthanthrones, quinacridones and carbon blacks.

As noted hereinbefore, the solder mask ink jet composition is of use in the manufacture of electronic devices comprising a dielectric substrate and electrically conductive circuitry such as PCB's. In this industrial sector the preferred colour is blue or green. The blue pigment is preferably one of the phthalocyamine series. Examples of blue pigments are C.I. Pigment Blue 1, 15, 15:1, 15:2, 15:3, 15:4, 15:6, 16, 24 and 60. Green pigments are generally a mixture of blue and yellow or orange pigments or may be green pigments per se such as halogenated phthalocyanines, for example copper or nickel brominated phthalocyanine.

The pigment is typically incorporated into the solder mask ink jet composition by milling it together with one or more of the acrylate functional monomers in the presence of a dispersant. The dispersant is preferably a polyester/polyamine and is, for example, a dispersant as disclosed in US 6,197,877. Dispersants of this type are available under the trademark Solsperse dispersants (Avecia Ltd). The dispersant may also include a synergist such as a quaternary ammonium salt of a partially sulphonated copper phthalocyanine pigment. Examples of such synergists are disclosed in GB-A-1508576, GB-A-2108143 and WO 01/14479 and are available under the Solsperse™ trademark.

The ratio of dispersant to synergist is typically from 1:1 to 10:1 by weight and is preferably about 5:1 by weight. The total amount of dispersant and synergist to pigment may vary over wide limits and is typically from 50% to 150% by weight relative to the weight of colorant. The amount of colorant in the solder mask ink is preferably not greater than 5 parts, more preferably not greater than 3 parts and especially not greater than 2 parts by weight.

The surfactant which is component F) of the solder mask ink composition when present may be any surface-active material which aids the homogeneity of the ink composition and provides desirable surface tension and wetting properties to the resultant ink. The surfactant may also be selected to adjust the viscosity of the ink composition to the desired limits. It is preferably anionic and especially non-ionic. It is also preferably aliphatic in nature, optionally containing silicon atoms and/or fluorine. The surfactant is preferably reactive with the acrylate monomers (component A)) and it is especially preferred that it contains one or more (meth)acrylate functional groups as defined hereinbefore. Examples of organic silicon acrylate surfactants are polysilicones containing repeat units of formula -Si(R¹,R¹)-O- where R¹ is monovalent hydrocarbyl which may be ethyl or aryl and also at least one group of formula -Si(X,R¹)-O- where X is a (meth)acrylate moiety. Specific examples are Tegorad™ 2200N and 2100 of Tego Chemie.

The solder mask ink preferably has a surface tension of from 20 to 40 and especially between 25 and 35 mN/m. Consequently, the amount of surfactant is generally from 0.1 to 0.6 parts by weight.

As will be understood from the term "comprises" the solder mask ink may contain further components in addition to components A) to F) which are commonly used in actinic radiation or particle beam curable compositions. Such adjuvants include slip modifiers, thixotropic agents, foaming agents, anti-foaming agents, waxes, oils, plasticisers, binders, antioxidants, photo-initiator stabilisers, gloss agents, fungicides, bactericides, organic and/or inorganic filler particles, levelling agents, opacifiers and antistatic agents. In a further embodiment the solder mask ink consists essentially of components A) to F) and in a still further embodiment the solder mask ink consists of components A) to F).

The solder mask ink may be prepared by any method known to the art of actinic radiation or particle beam curable compositions. Typically, the components A) and B) are mixed together with rapid stirring at a temperature from 20 to 60°C, preferably under reduced light conditions, until a homogenous solution is obtained. Component C) is then added and stirring continued at 20 to 60°C under reduced light conditions. Finally, optional components D), E) and F) are added.

As noted hereinbefore component E) is preferably a pigment, especially a blue pigment and is preferably prepared by any suitable attrition process such as grinding, pebble or bead milling the pigment together with dispersant in the presence of small amounts of component A). When component E) is a pigment it is added to the other components of the ink is a pre-dispersed form.

The ink composition is then preferably filtered at 20 to 25°C to remove any particulate matter. Filtration may include a process known as cascade filtration when the ink composition passes through successively finer filter media, for example, 10, 6, 4.5, 2.5 and 1.2 micron filters.

In one embodiment the solder mask ink is not removed from the substrate using alkali.

As noted hereinbefore the process according to the invention is mainly concerned with the manufacture of printed circuit boards. After polymerisation of the solder mask ink by actinic or particle beam radiation and optionalthermal curing the cured ink preferably exhibits the following properties both individually and collectively:
- Good adhesion to a dielectric substrate with electrically conductive metal or alloy circuitry for a solder mask coating of from 10 to 30µm thickness as determined using ASTR test method D3359-87.
- The polymerised solder mask withstands molten for at least 10 seconds at 200°C and especially at 260°C according to IPC test method 3.7.2 of IPC-SM-840C.
- Pencil hardness for a 10 to 30µm thick film of not less than F and especially not less than 3H as determined using IPC test method TR 2.4.27.2 of IPC-TM-650.
- Withstand dielectric breakdown of not less than 500 volts/25µm film thickness as determined by IPC test method TR 2.5.6.1 of IPC-SM-840C.
- Surface resistivity between adjacent electrically conductive tracks of the circuitry which is not less than 5 x 10⁹ ohms as determined by test method 2.6.3.1 of IPC-SM-840C.

As noted hereinbefore, the process according to the invention is particularly suited for making PCB's, especially wherein the electrically conductive circuitry is copper. Thus, according to a further aspect of the invention, there is provided an electronic device comprising a dielectric substrate containing electrically conductive metal circuitry and a solder mask which has been prepared using the process as described hereinbefore.

Some of the solder mask inks used in the process of the invention form a further feature of the present invention. Thus, according to a further aspect of the invention, there is provided a non-aqueous solder mask ink which is substantially free from organic solvents which comprises the following components:
A) 30 to 90 parts acrylate functional monomers which are mono or higher acrylate functional monomers comprising from 5 - 95% by weight of one or more monofunctional monomers;
B) 0.1 to 30 parts metal adhesion promoting organic compound;
C) 5 to 30 parts initiator;
D) 0 to 10 parts polymer and/or prepolymer;
E) 0 to 5 parts colorant;
F) 0 to 5 parts surfactant; and
wherein the ink has a viscosity of not greater than 30 cPs (mPa.s) at 40°C and all parts are by weight.

According to a still further aspect of the invention there is provided a non-aqueous solder mask ink which is substantially free from organic solvents which comprises:
A) 30 to 90 parts acrylate functional monomers which are mono or higher acrylate functional monomers comprising 5 - 95% by weight of one or more mono-functional monomers;
B) 0.1 to 30 parts metal adhesion promoting organic compound containing one or more carboxylic acid groups and having an acid value of not greater than 120 mg KOH/g;
C) 5 to 30 parts initiator;
D) 0 to 10 parts polymer and/or prepolymer;
E) 0 to 5 parts colorant;
F) 0 to 5 parts surfactant;
wherein the ink has a viscosity of not greater than 20 cPs (mPa.s) at 40°C and all parts are by weight.

Preferably the metal adhesion promoting organic compound containing one or more carboxylic acid groups has an acid value of not greater than 30 mg KOH/g.

According to a further aspect of the invention there is provided a non-aqueous solder mask ink which is substantially free from organic solvents which comprises the components:
A) 30 to 90 parts acrylate functional monomers which are mono or higher acrylate functional monomers comprising 5 - 95% by weight of one or more mono-functional monomers;
B) 0.1 to 30 parts metal adhesion promoting organic compound containing one or more carboxylic acid groups;
C) 5 to 30 parts initiator;
D) 0 to 10 parts polymer and/or prepolymer;
E) 0 to 5 parts colorant;
F) 0 to 5 parts surfactant; and
wherein the acid value of the total solder mask ink is not greater than 30 mg KOH/g and all parts are by weight.

In one embodiment of the above inks the number of parts of components A) + B) + C)+D)+E)+F)=100.

The solder mask inks may also be used for printing legends onto electronic devices and are particularly well suited to printing onto polyacrylate solder masks, especially following exposure to actinic or particle beam (electron) radiation and optionally prior to thermal treatment.

The solder mask inks of the present invention may of course contain further components (other than trace amounts of water and organic solvents) in addition to components A) to F) specified above, for example preservatives, biocides, rheology modifiers, surfactants, levelling agents, antifoaming agents, anti-kogation agents and combinations thereof. The solder mask inks are generally made available to the manufacturer of electronic devices in the form of replacement cartridges for ink jet printers. Hence, according to a further aspect of the invention, there is provided a cartridge for an ink jet printer comprising a chamber and an ink wherein the ink is present in the chamber and the ink is a solder mask ink as described hereinbefore.

The present invention also provides an electronic device obtained by a process according to the present invention.

The invention is further illustrated by the following examples wherein all references are to parts by weight unless expressed to the contrary.

### Examples 1 to 74

The acrylate monomers and metal adhesion promoter were mixed by stirring at 25°C for about 1 hour to give a homogeneous solution. The initiator was then added under reduced light conditions and the mixture stirred at 60°C to dissolve the initiator. The mixture was then cooled to 25°C and the surfactant was added with stirring.

The pigment and dispersant were milled for 16 hours at 25°C in the presence of a small amount of acrylate monomers and adhesion promoter and 3mm diameter balatini glass beads using a horizontal shaker. The beads were then removed and the pigment dispersion was added to the above mixture. The resulting ink was then filtered using a cascade series of filters with pore sizes of 10, 6, 4.5, 2.5 and 1.2µ.

The composition of the solder mask ink is detailed in Table 1 below.

The following ink properties were determined as follows:

Viscosity was measured at 40°C using a Brookfield Viscometer equipped with a number 18 spindle rotating at 100 rpm.

Surface tension was measured at 25°C using a DuNouy ring.

Ink jet start up and firing was assessed using a Spectra Galaxy 30pl print head and the results assessed as good, moderate or poor.

The solder mask ink was then applied to an uncoated dielectric FR4 board laminated with 30µm copper sheet to a thickness of 25mm either using a K-bar or block printing with a Spectra Galaxy ink jet printer. The solder mask was then cured by passing a UV "Fusion D bulb" running at 120W/cm with energy output of 300-900 MJ/cm (or 2.8 - 3.6 W/cm² at a pass speed of 10 - 35 m/min. After UV curing, the solder mask ink was thermally cured by heating for 60 min in a fan oven at 150°C.

The following properties of the cured solder mask ink were measured as follows:

Pencil harness using IPC test method TM 2.4.27.2 of IPC-TM-650.

Adhesion using ASTM test method D3359-87 both before and after thermal curing and quantified as good, moderate or poor.

Resistance to hot solder in a solder bath heated to 260°C for 10 seconds using IPC test method 3.7.2. of IPC-SM-840C.

Dielectric breakdown voltage using IPC test method TM 2.5.6.1 of IPC-TM-650.

Resistance to solvents using IPC test method 3.6.1.1 of IPC-SM-840C.

The results were given in Table 2 below.

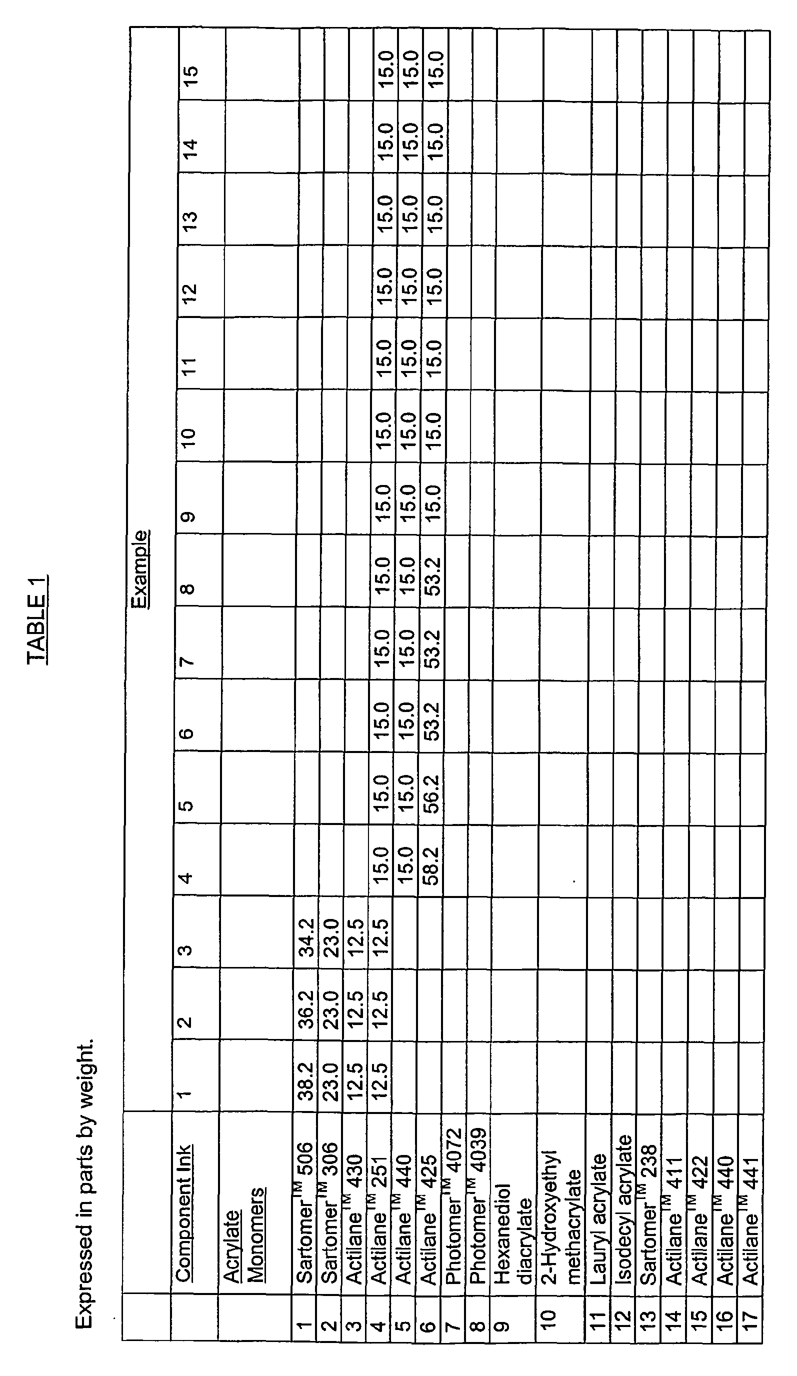

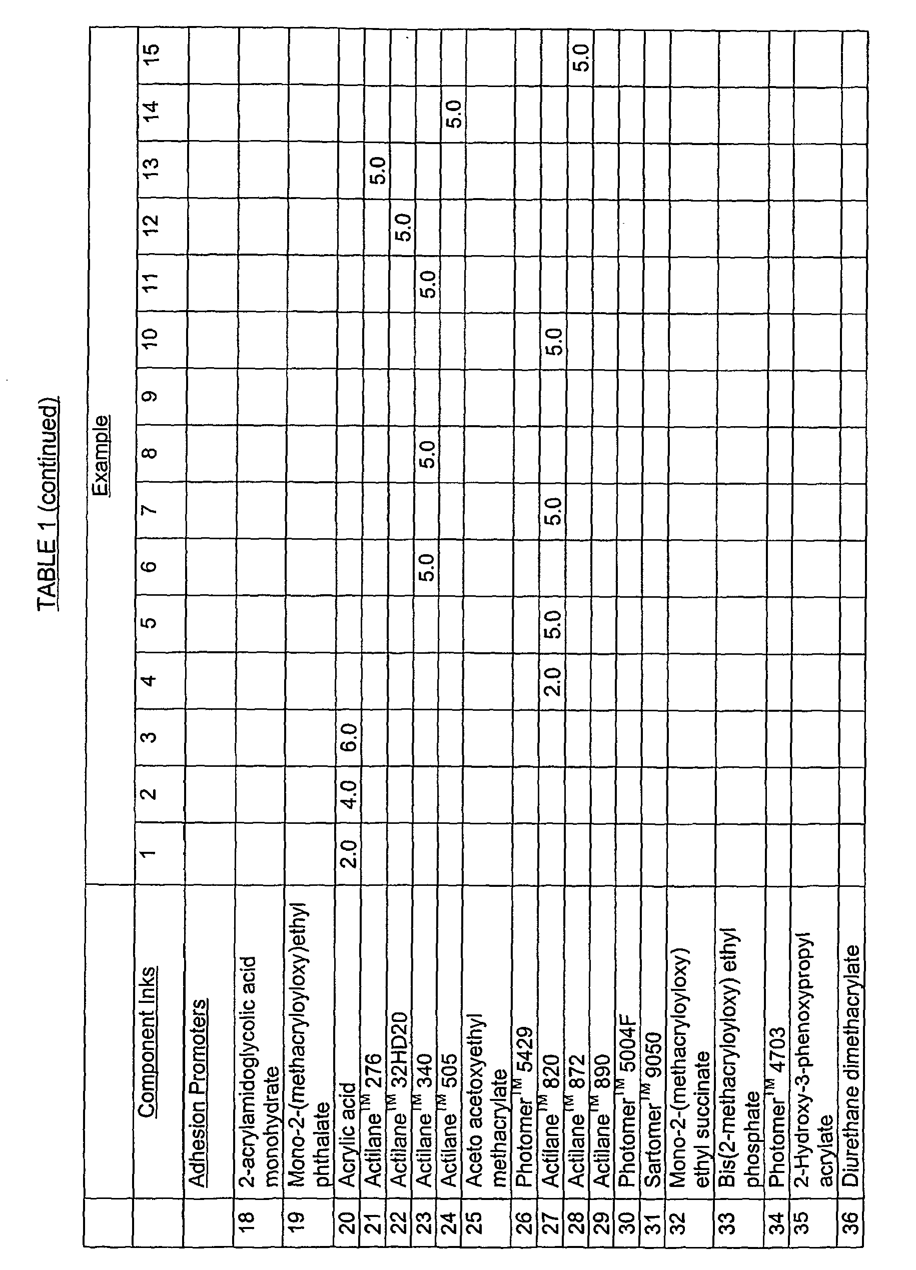

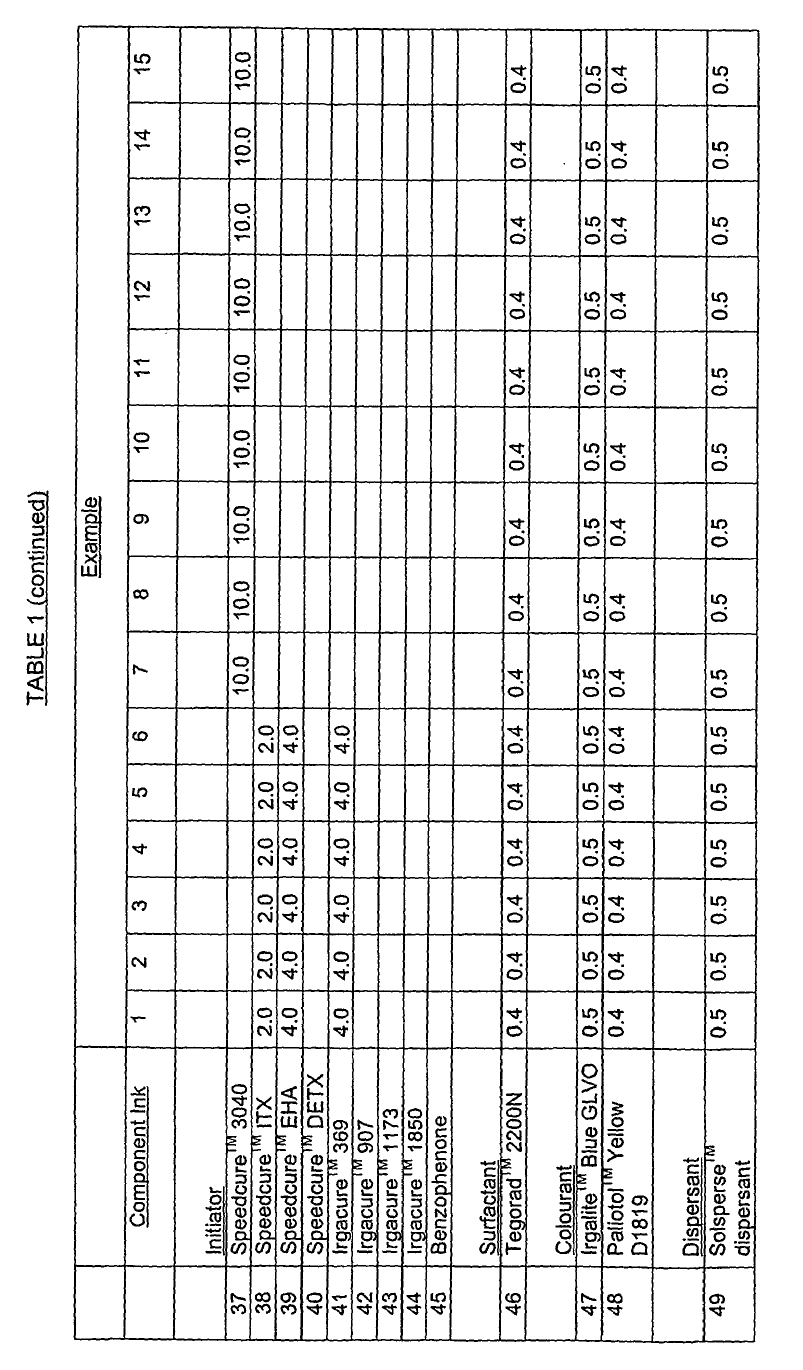

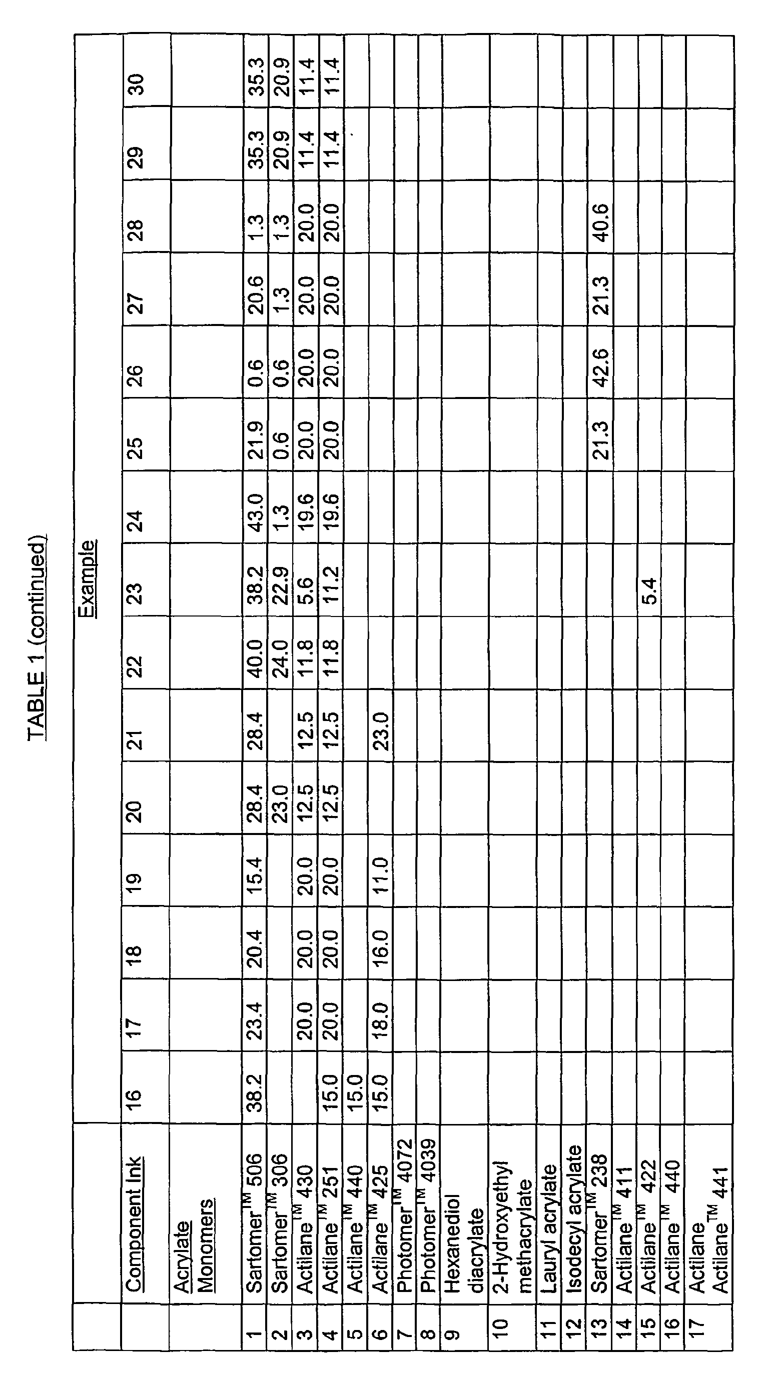

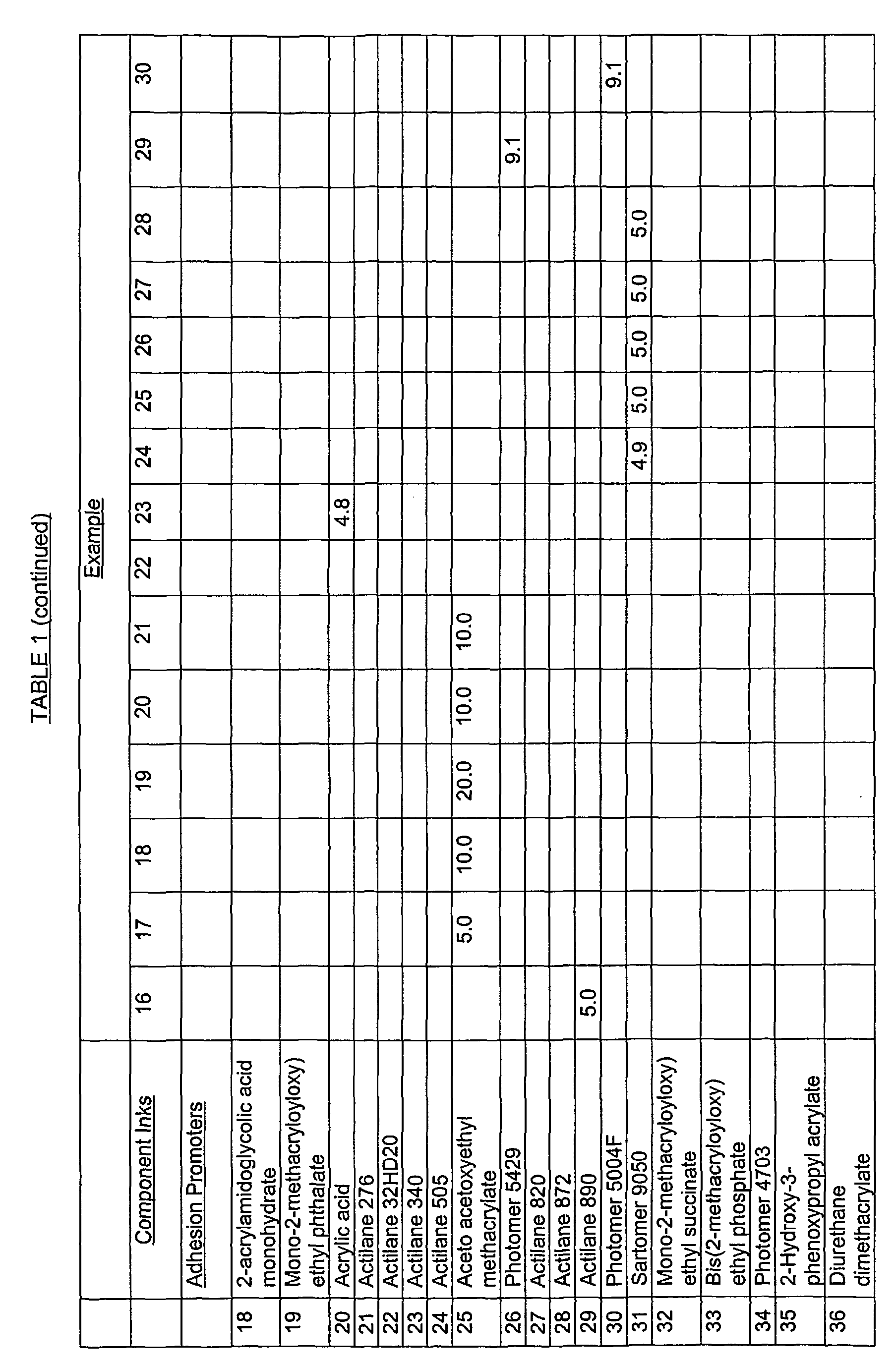

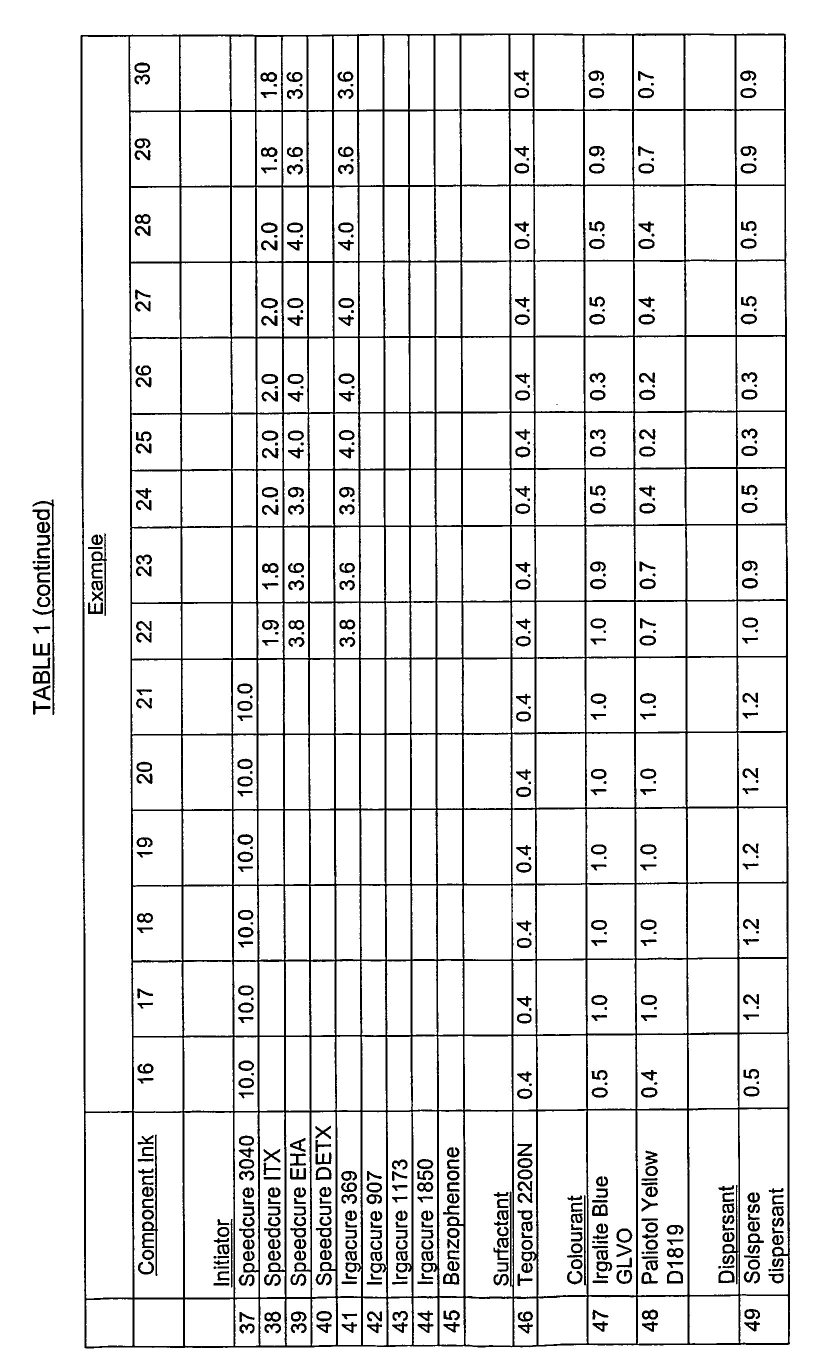

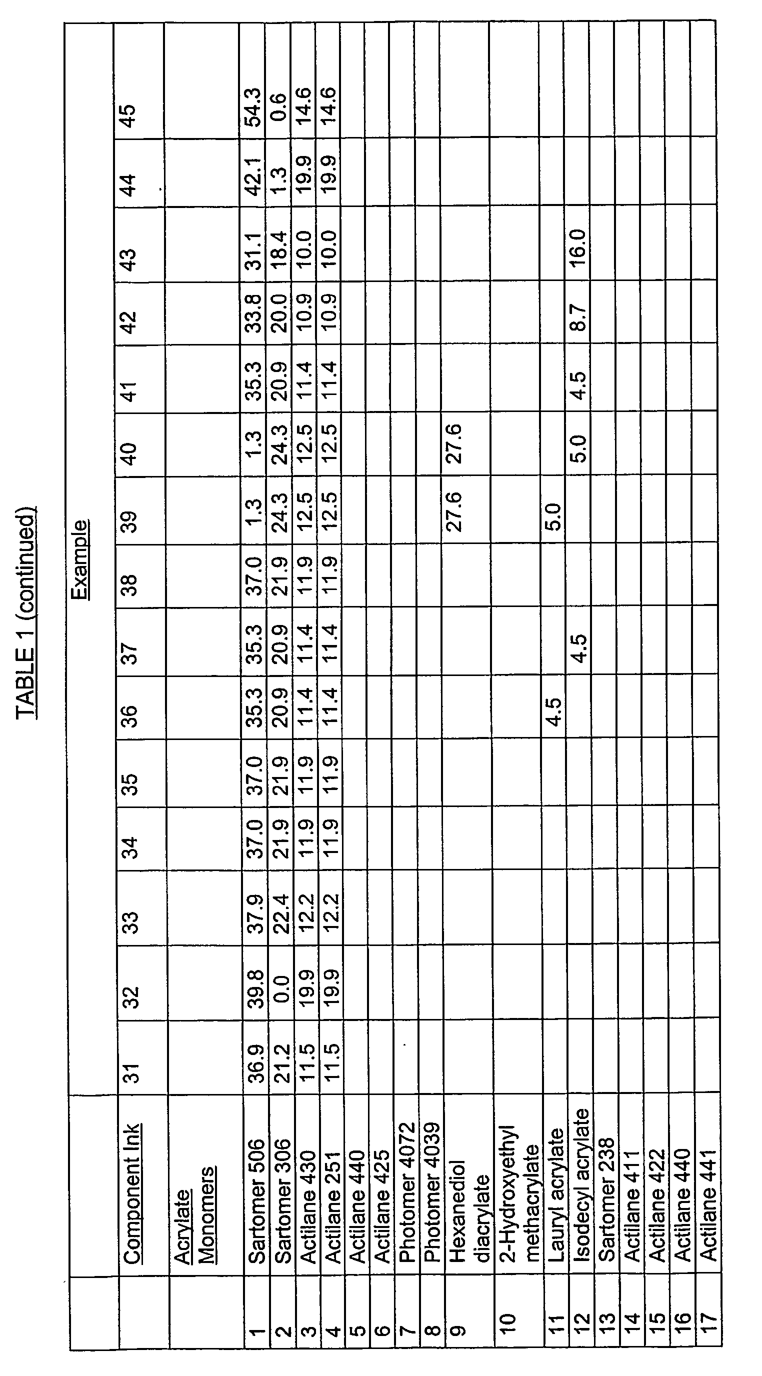

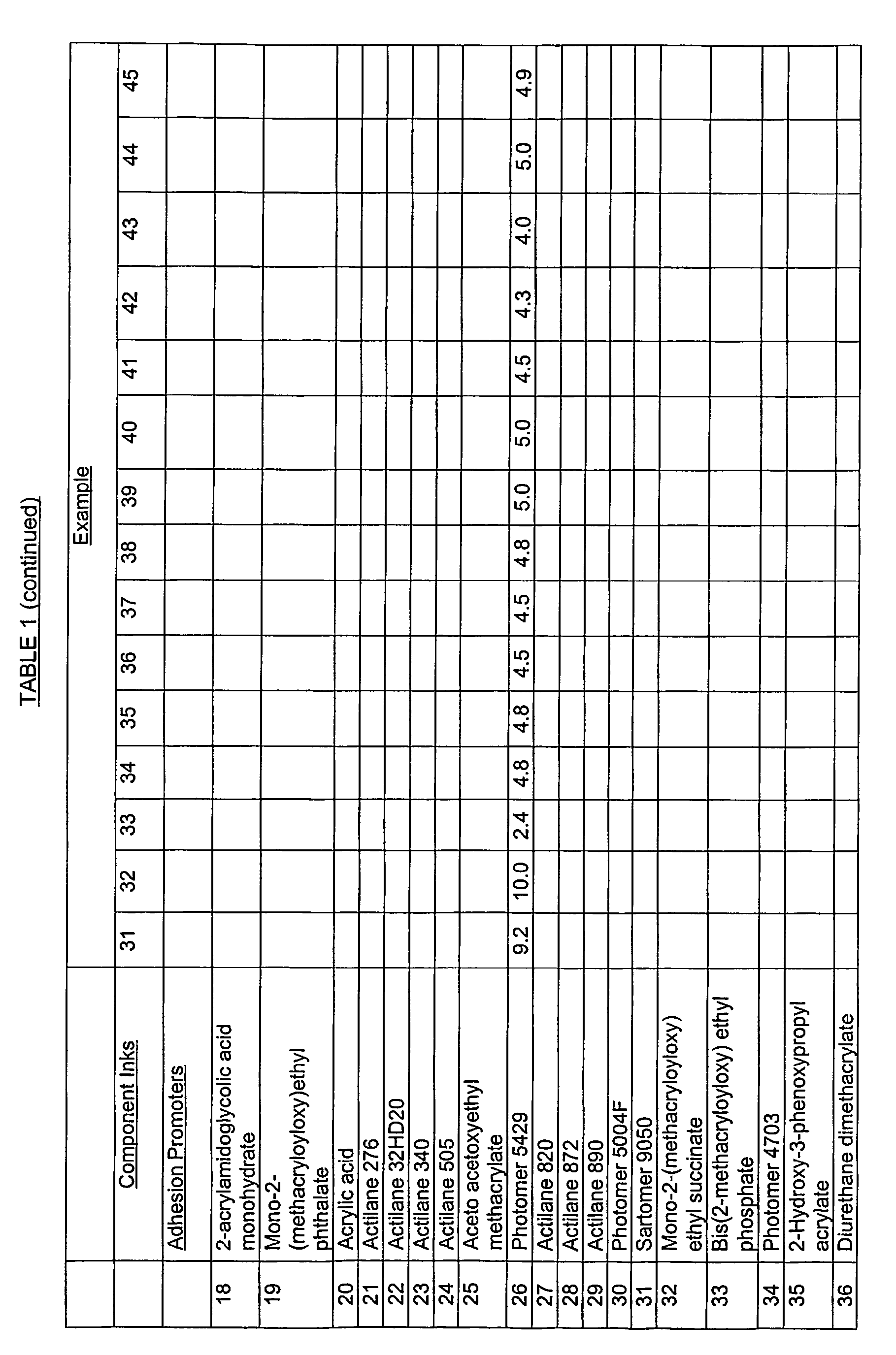

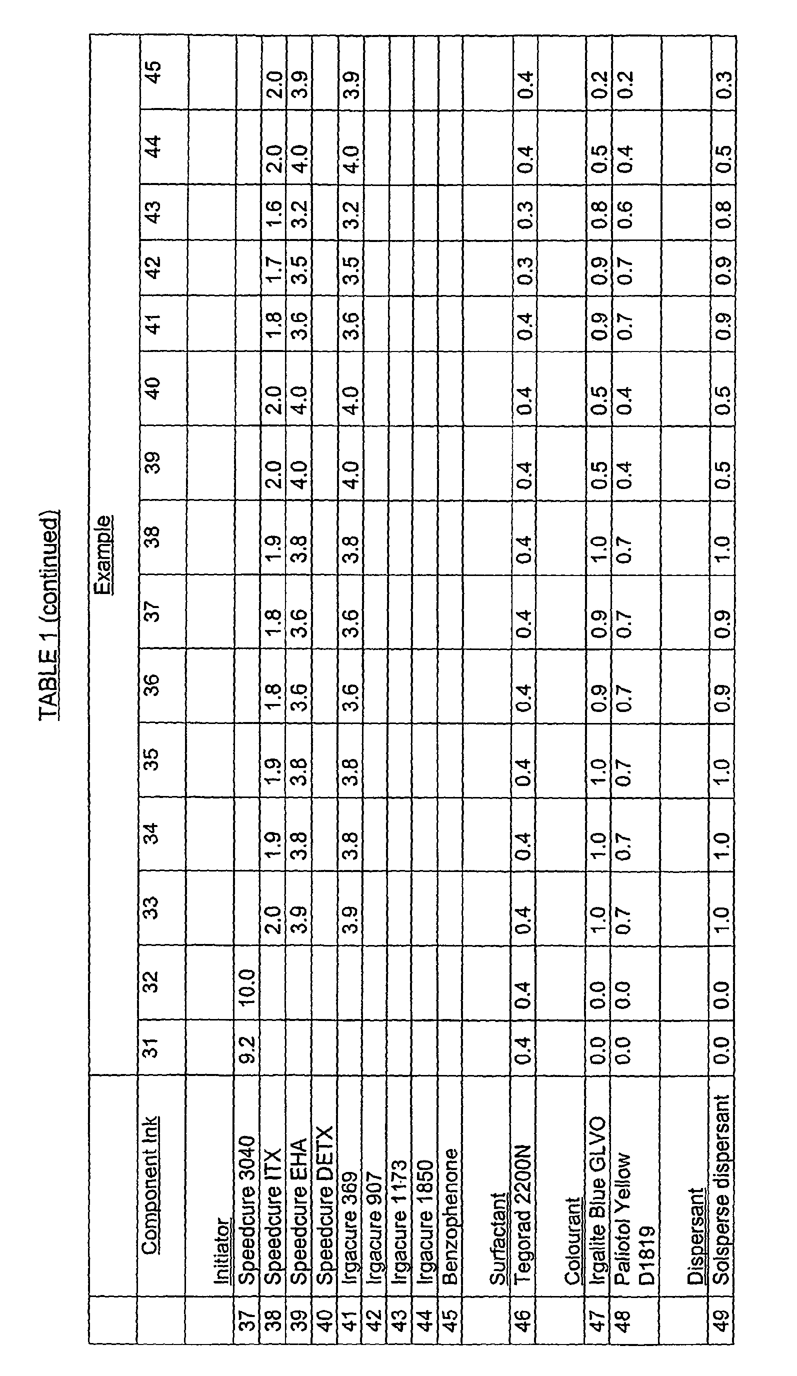

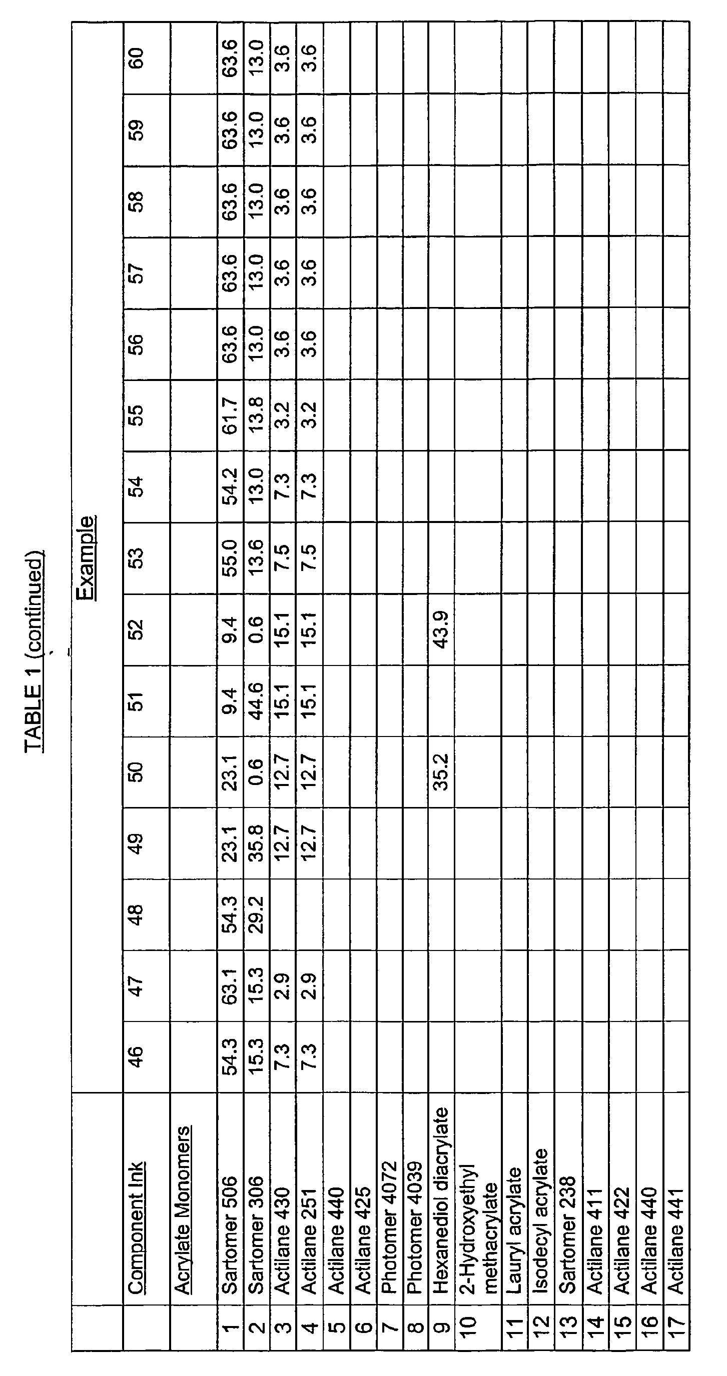

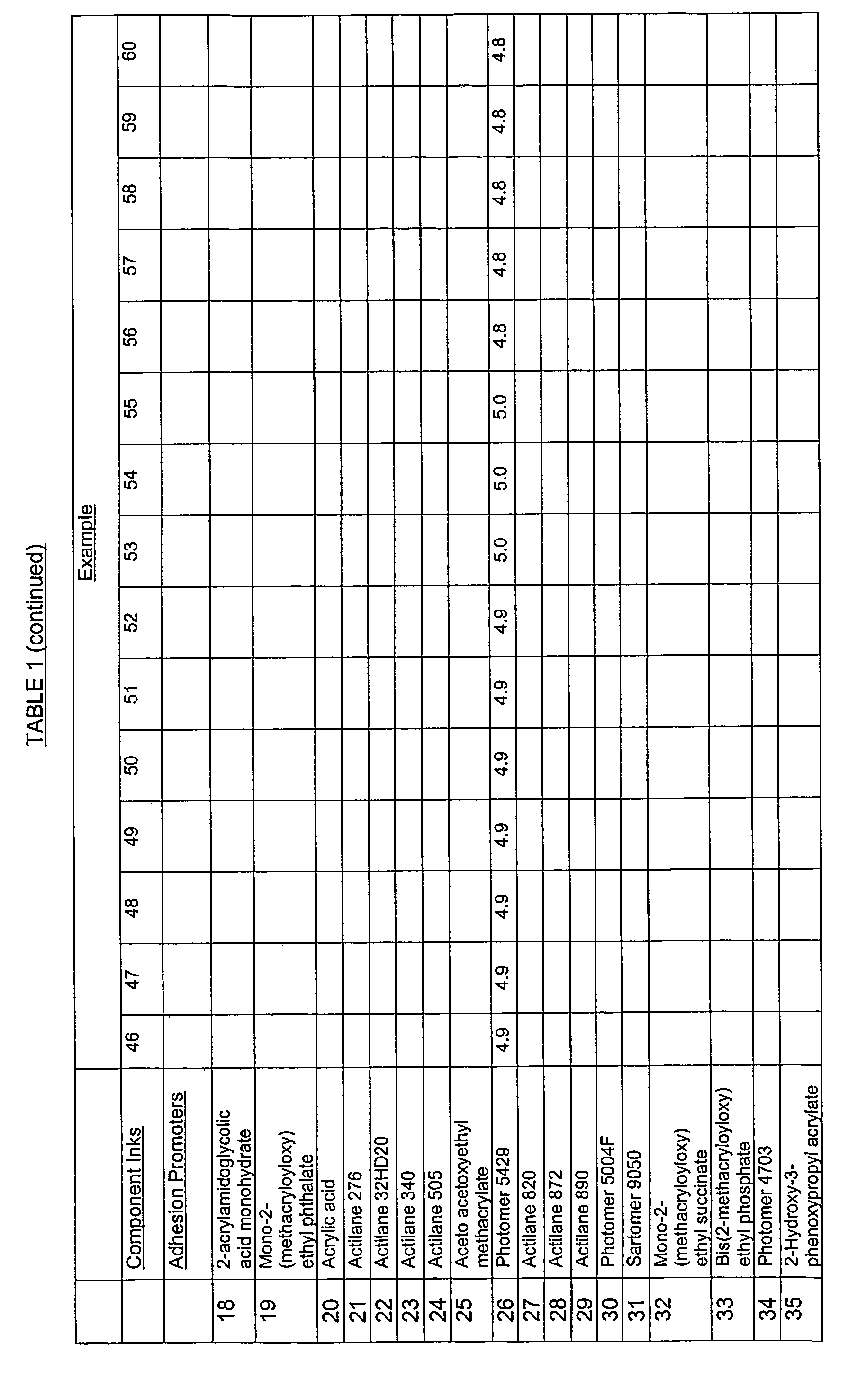

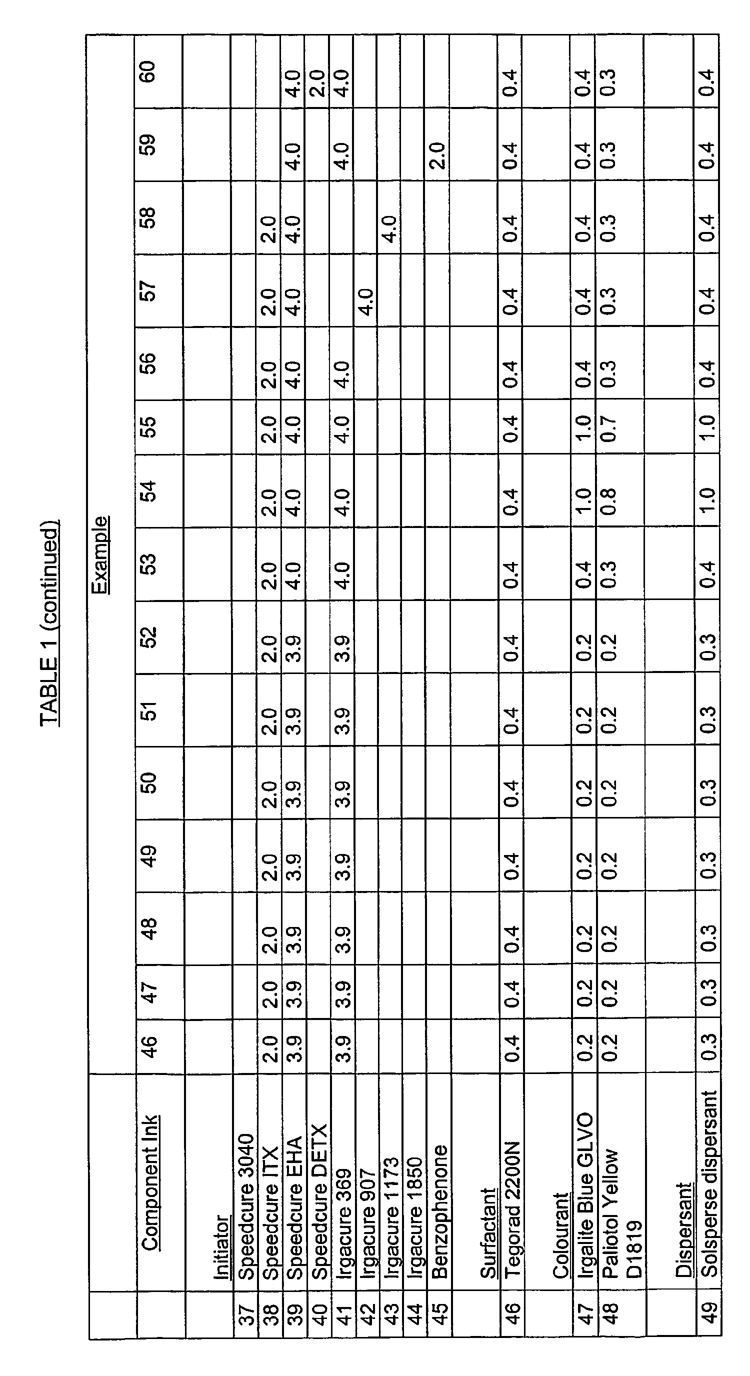

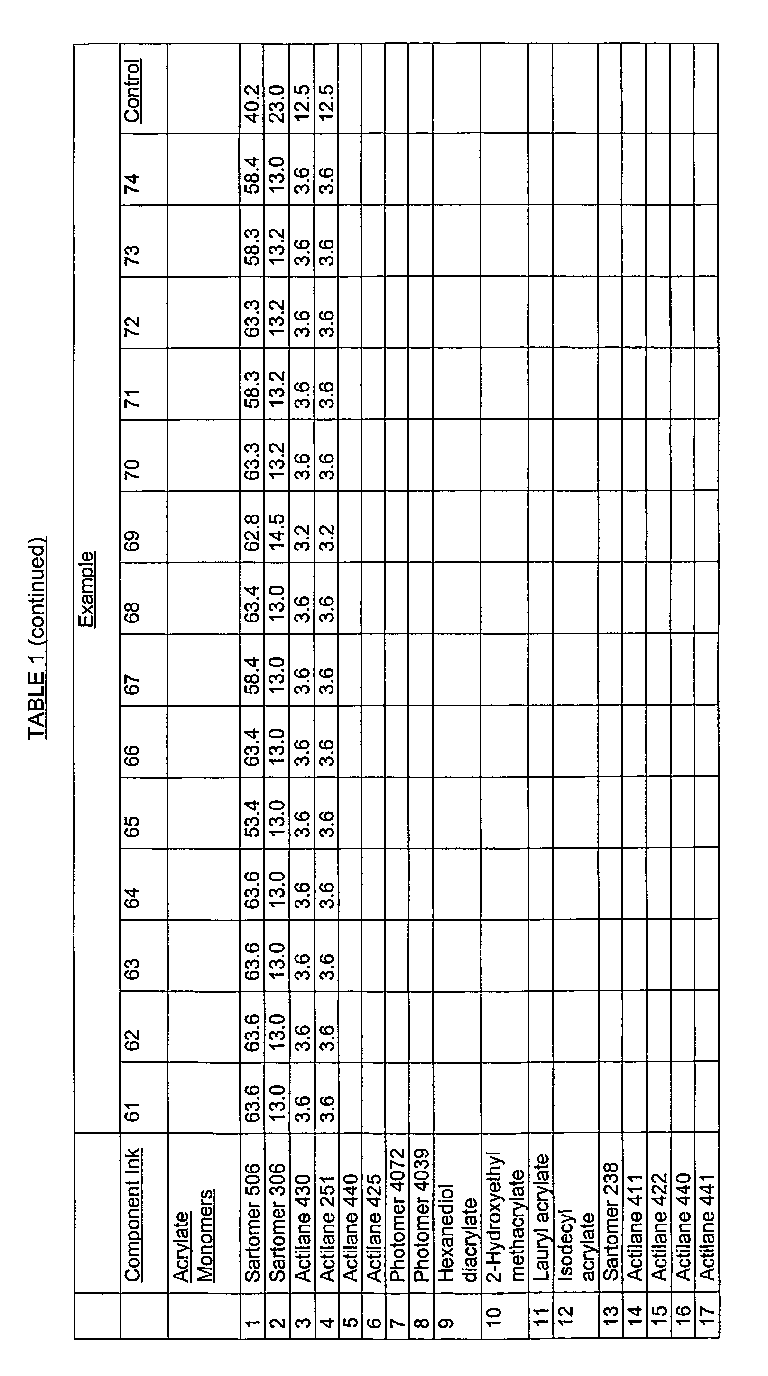

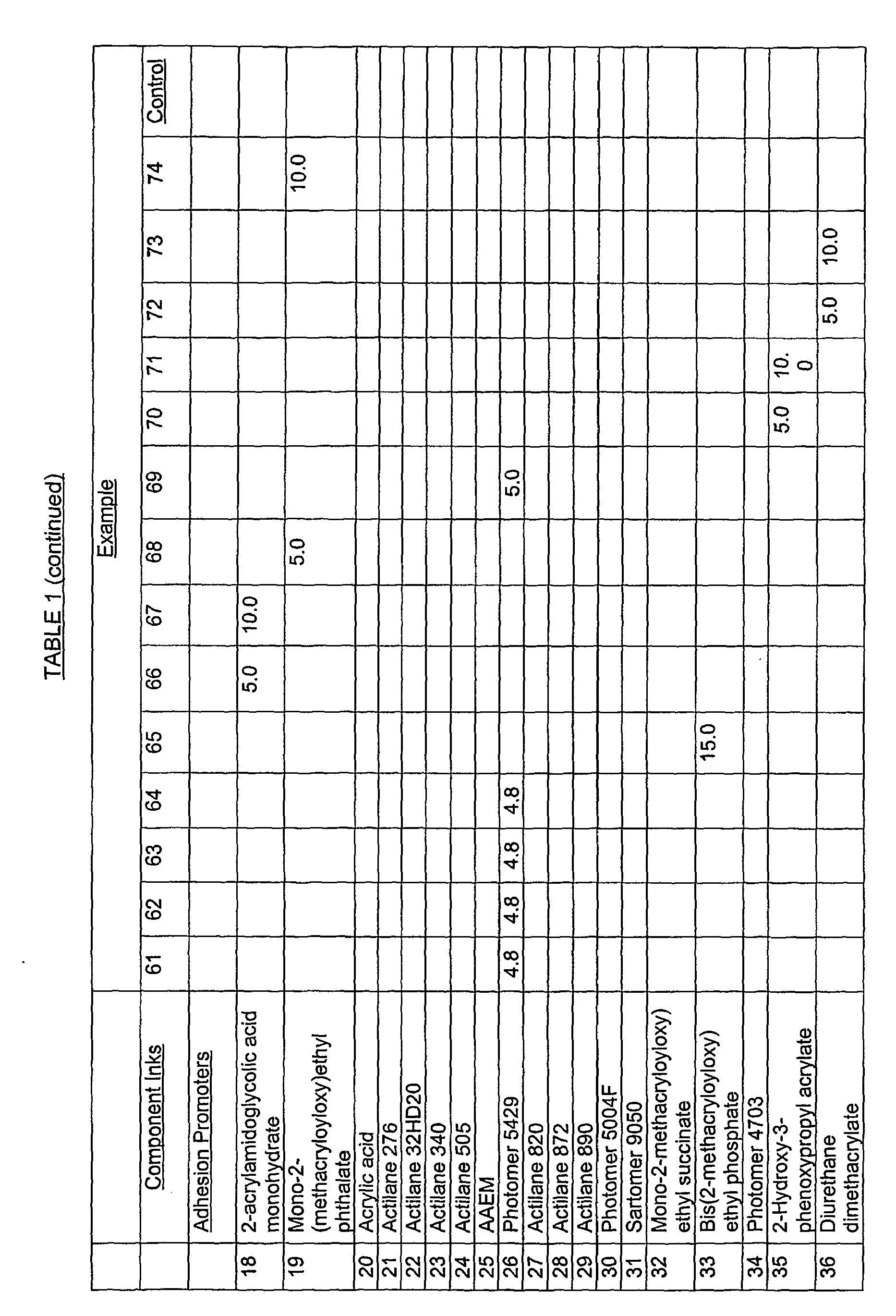

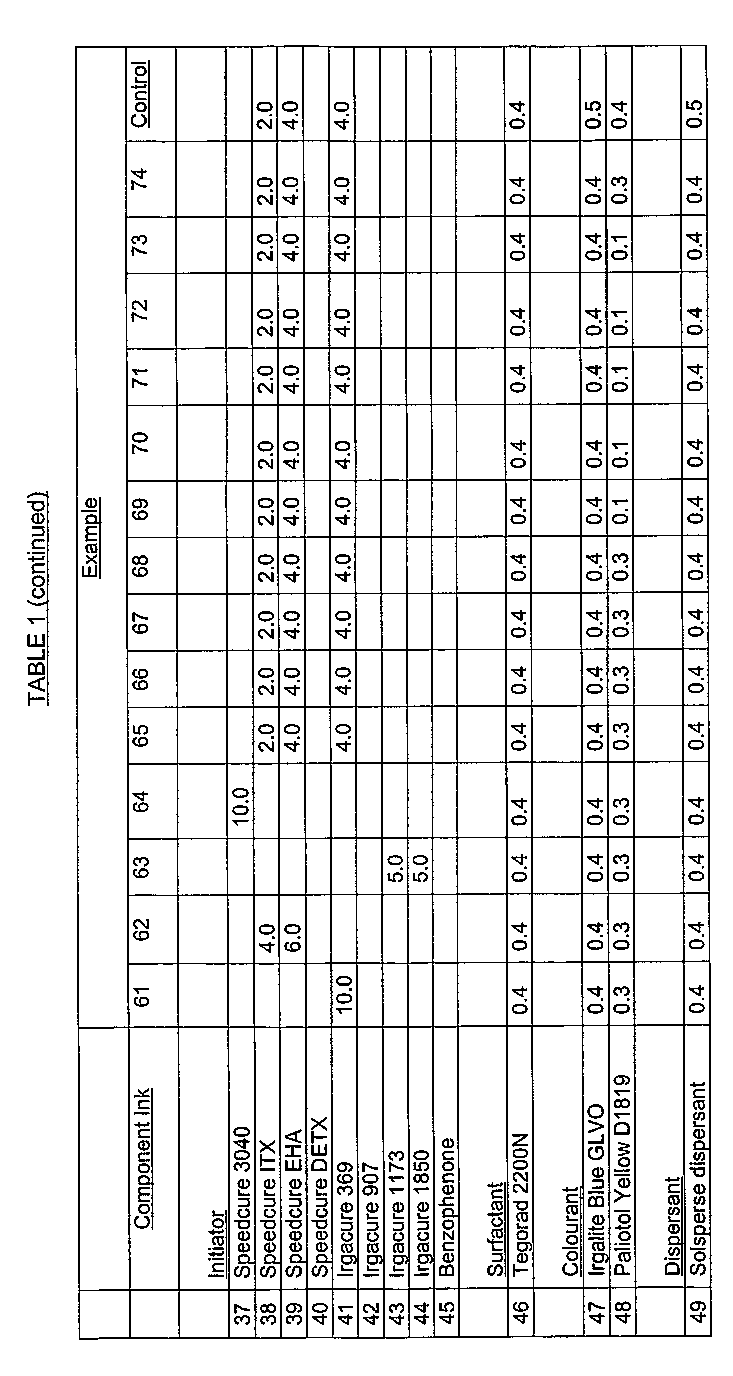

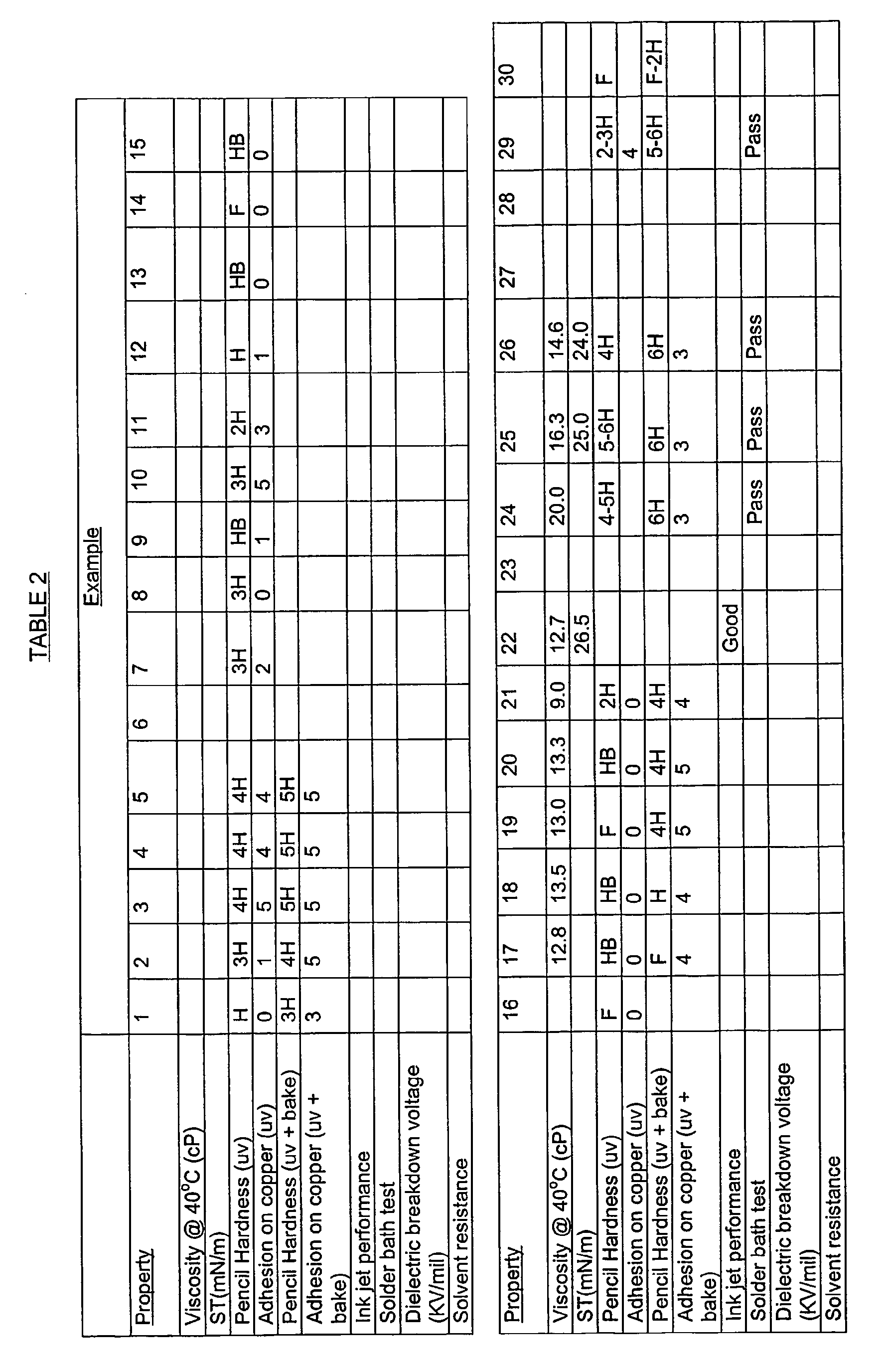

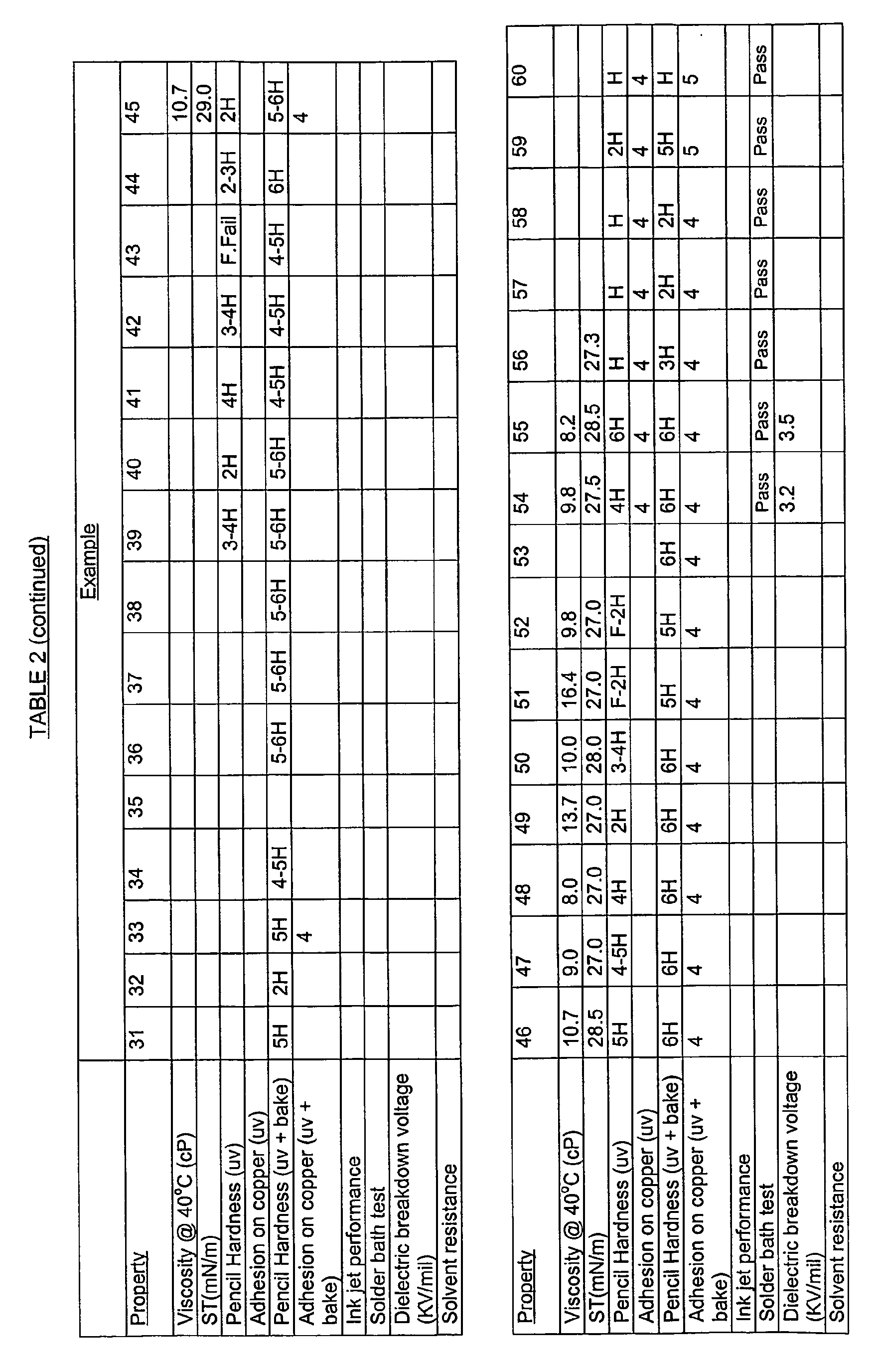

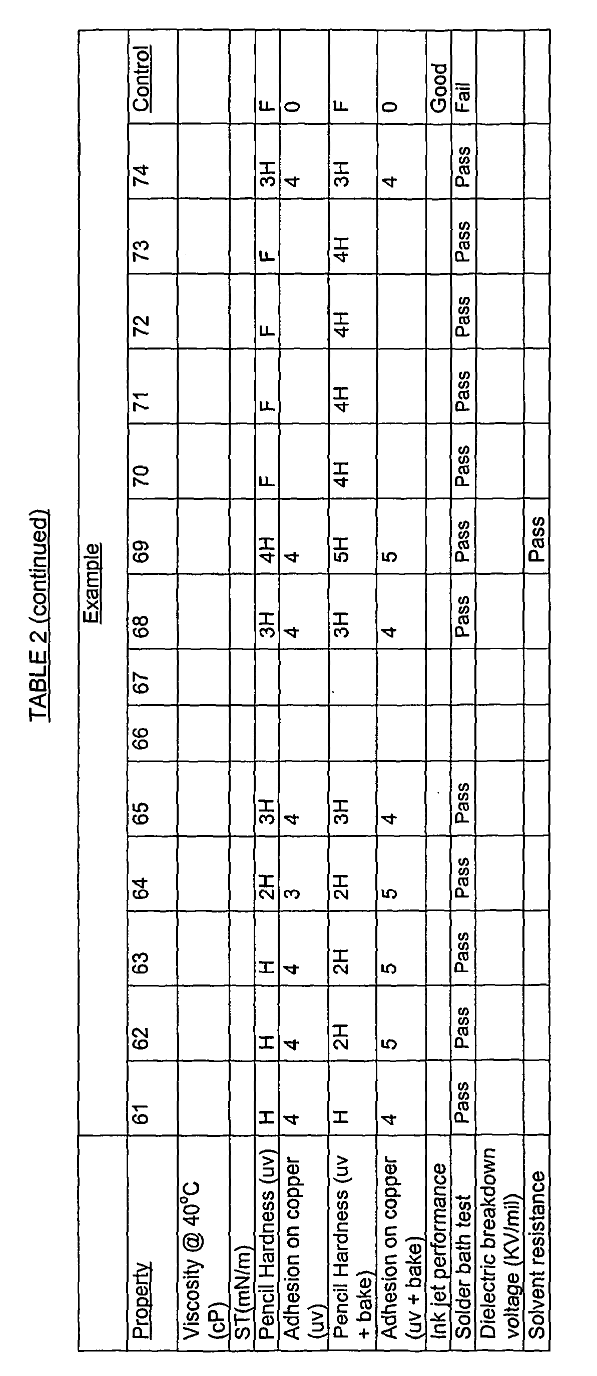

## Claims

1. A process for making an electronic device which comprises applying a non-aqueous solder mask ink which is substantially free from organic solvent to a dielectric substrate containing electrically conductive metal circuitry, exposing the solder mask ink to actinic radiation and/or particle beam radiation optionally followed by thermal treatment, whereby the solder mask ink is applied to selected areas of the substrate under the control of a computer by ink jet printing and wherein the solder mask ink comprises the components:
A) 30 - 90 parts acrylate functional monomers which are mono or higher acrylate functional monomers comprising from 5 - 95% by weight of one or more monofunctional monomers;
B) 0.1 - 30 parts metal adhesion promoting organic compound;
C) 0 - 30 parts initiator;
D) 0 - 10 parts polymer and/or prepolymer;
E) 0 - 5 parts colorant;
F) 0 - 5 parts surfactant; and
wherein all parts are by weight.

2. A process as claimed in claim 1 wherein the viscosity of the solder mask ink is from 8 to 20 cPs (mPa.s) at 40°C.

3. A process as claimed in either claim 1 or claim 2 wherein the weight average molecular weight of the acrylate functional monomer is not greater than 2.000.

4. A process as claimed in any one of claims 1 to 3 wherein the acrylate functional monomer is isobornyl acrylate, tripropylene glycol diacrylate or trimethylolpropane ethoxylate triacrylate.

5. A process as claimed in any one of claims 1 to 4 wherein the amount of mono-functional acrylate monomer is 70-95% by weight of the acrylate-functional monomer (component A)).

6. A process as claimed in any one of claims 1 to 5 wherein the adhesion promoter is an acrylate functional monomer.

7. A process as claimed in any one of claims 1 to 6 wherein the adhesion promoter contains a metal chelant group which is a carboxylic acid.

8. A process as claimed in claim 7 wherein the adhesion promoter is (meth)acrylic acid.

9. A process as claimed in any one of claims 1 to 8 wherein the adhesion promoter is a polypropylene glycol tetra acrylate containing (meth)acrylic acid.

10. A process as claimed in claim 9 wherein the adhesion promoter has an acid value of not greater than 120 mg KOH/g.

11. A process as claimed in any one of claims 1 to 10 wherein the amount of adhesion promoter is not greater than 15 parts by weight.

12. A process as claimed in any one of claims 1 to 11 wherein the electronic device is a printed circuit board.

13. A process as claimed in any one of claims 1 to 12 wherein the solder mask ink has an acid value of not greater than 30 mg KOH/g.

14. A process as claimed in any one of claims 1 to 13 wherein the amount of initiator is not less than 5 parts.

15. A process as claimed in any one of claims 1 to 14 wherein the number of parts of components A) + B) + C) + D) + E) + F) = 100.

16. A non-aqueous solder mask ink which is substantially free from organic solvents which comprises the components:
A) 30 to 90 parts acrylate functional monomers which are mono or higher acrylate functional monomers comprising from 5 - 95% by weight of one or more monofunctional monomers ;
B) 0.1 to 30 parts metal adhesion promoting organic compound;
C) 5 to 30 parts initiator;
D) 0 to 10 parts polymer and/or prepolymer,
E) 0 to 5 parts colorant;
F) 0 to 5 parts surfactant; and
wherein the ink has a viscosity of not greater than 30 cPs (mPa.s) at 40°C and all parts are by weight.

17. A non-aqueous solder mask ink according to claim 16 wherein component B) is 0.1 to 30 parts metal adhesion promoting organic compound containing one or more carboxylic acid groups and having an acid value of not greater than 120 mg KOH/gm; and the ink has a viscosity of not greater than 20 cPs (mPa.s) at 40°C.

18. A non-aqueous solder mask ink according to claim 16 wherein component B) is 0.1 to 30 parts metal adhesion promoting organic compound containing one or more carboxylic acid groups; and the acid value of the total solder mask ink is :not greater than 30mg KOH/g.

19. An ink as claimed in any one of claims 16 to 18 wherein the number of parts of components A) + B) + C) + D) + E) + F) = 100.

20. A cartridge for an ink jet printer comprising a chamber and an ink wherein the ink is present in the chamber and the ink is a solder mask ink as claimed in any one of claims 16 to 19.

21. An electronic device obtained by a process according to any one of claims 1 to 15.

## Patentansprüche

1. Verfahren zur Herstellung eines elektronischen Geräts, das das Aufbringen einer nicht wässrigen Lötmaskentinte, die im Wesentlichen frei von organischen Lösemitteln ist, auf ein dielektrisches Substrat, das elektrisch leitende Metallschaltungen enthält, das Exponieren der Lötmaskentinte an eine aktinische Strahlung und/oder Teilchenstrahlung, optional gefolgt von einer thermischen Behandlung, wobei die Lötmaskentinte mittels Tintenstrahldruck, der von einem Computer gesteuert wird, auf ausgewählte Bereiche des Substrats aufgebracht wird, umfasst, und wobei die Lötmaskentinte folgende Komponenten umfasst:
A) 30 bis 90 Anteile funktioneller Acrylatmonomere, die monofunktionelle oder höherfunktionelle Acrylatmonomere sind, die 5 bis 95 Gew.-% eines oder mehrerer monofunktioneller Monomere umfassen;
B) 0,1 bis 30 Anteile einer die Metalladhäsion fördernden organischen Verbindung;
C) 0 bis 30 Anteile eines Initiators;
D) 0 bis 10 Anteile eines Polymers und/oder eines Präpolymers;
E) 0 bis 5 Anteile eines Farbstoffs;
F) 0 bis 5 Anteile einer oberflächenaktiven Substanz; und
wobei alle Anteile Gewichtanteile sind.

2. Verfahren nach Anspruch 1, wobei die Viskosität der Lötmaskentinte bei 40 °C zwischen 8 und 20 cPs (mPa. s) liegt.

3. Verfahren nach Anspruch 1 oder 2, wobei das Gewichtsdurchschnitts-Molekulargewicht des funktionellen Acrylatmonomers 2.000 nicht übersteigt.

4. Verfahren nach einem der Ansprüche 1 bis 3, wobei das funktionelle Acrylatmonomer ein Isobornylacrylat, Tripropylenglycoldiacrylat oder Trimethylolpropan-ethoxylat-triacrylat ist.

5. Verfahren nach einem der Ansprüche 1 bis 4, wobei die Menge des monofunktionellen Acrylatmonomers zwischen 70 und 95 Gew.-% des funktionellen Acrylatmonomers liegt (Komponente A)).

6. Verfahren nach einem der Ansprüche 1 bis 5, wobei der Haftvermittler ein funktionelles Acrylatmonomer ist.

7. Verfahren nach einem der Ansprüche 1 bis 6, wobei der Haftvermittler eine Metallchelatgruppe enthält, die eine Carbonsäure ist.

8. Verfahren nach Anspruch 7, wobei der Haftvermittler eine (Meth)Acrylsäure ist.

9. Verfahren nach einem der Ansprüche 1 bis 8, wobei der Haftvermittler ein Polypropylenglycoltetraacrylat ist, das (Meth)Acrylsäure enthält.

10. Verfahren nach Anspruch 9, wobei die Säurezahl des Haftvermittlers 120 mg KOH/g nicht übersteigt.

11. Verfahren nach einem der Ansprüche 1 bis 10, wobei die Haftvermittlermenge nicht mehr als 15 Gewichtsanteile beträgt.

12. Verfahren nach einem der Ansprüche 1 bis 11, wobei das elektronische Gerät eine gedruckte Leiterplatte ist.

13. Verfahren nach einem der Ansprüche 1 bis 12, wobei die Säurezahl der Lötmaskentinte 30 mg KOH/g nicht übersteigt.

14. Verfahren nach einem der Ansprüche 1 bis 13, wobei die Initiatormenge nicht weniger als 5 Gewichtsanteile beträgt.

15. Verfahren nach einem der Ansprüche 1 bis 14, wobei die Anzahl der Anteile der Komponenten A) + B) + C) + D) + E) + F) = 100 ist.

16. Nicht wässrige Lötmaskentinte, die im Wesentlichen frei von organischen Lösemitteln ist, die folgende Komponenten umfasst:
A) A) 30 bis 90 Anteile funktioneller Acrylatmonomere, die monofunktionelle oder höherfunktionelle Acrylatmonomere sind, die 5 bis 95 Gew.-% eines oder mehrerer monofunktioneller Monomere umfassen;
B) 0,1 bis 30 Anteile einer die Metalladhäsion fördernden organischen Verbindung;
C) 5 bis 30 Anteile eines Initiators;
D) 0 bis 10 Anteile eines Polymers und/oder eines Präpolymers;
E) 0 bis 5 Anteile eines Farbstoffs;
F) 0 bis 5 Anteile einer oberflächenaktiven Substanz; und
wobei die Tinte eine Viskosität aufweist, die bei 40 °C nicht über 30 cPs (mPa. s) liegt, und wobei alle Anteile Gewichtsanteile sind.

17. Nicht wässrige Lötmaskentinte nach Anspruch 16, wobei die Komponente B) aus 0,1 bis 30 Anteilen einer die Metalladhäsion fördernden organischen Verbindung besteht, die eine oder mehrere Carbonsäuregruppen enthält und einen Säurewert hat, der 120 mg KOH/gm nicht übersteigt; und wobei die Tinte eine Viskosität aufweist, die bei 40 °C nicht über 20 cPs (mPa. s) liegt.

18. Nicht wässrige Lötmaskentinte nach Anspruch 16, wobei die Komponente B) aus 0,1 bis 30 Anteilen einer die Metalladhäsion fördernden organischen Verbindung besteht, die eine oder mehrere Carbonsäuregruppen enthält, wobei die Säurezahl der gesamten Lötmaskentinte 30 mg KOH/g nicht übersteigt.

19. Verfahren nach einem der Ansprüche 16 bis 18, wobei die Anzahl der Anteile der Komponenten A) + B) + C) + D) + E) + F) = 100 ist.

20. Patrone für einen Tintenstrahldrucker, der eine Kammer und eine Tinte umfasst, wobei die Tinte in der Kammer vorhanden ist, und die Tinte eine Lötmaskentinte nach einem der Ansprüche 16 bis 19 ist.

21. Elektronisches Gerät, das durch ein Verfahren nach einem der Ansprüche 1 bis 15 erhalten wird.

## Revendications

1. Procédé de fabrication d'un dispositif électronique qui comprend l'application d'une encre épargne de soudure non aqueuse qui est essentiellement exempte de solvant organique sur un substrat diélectrique contenant des circuits métalliques conducteurs de l'électricité, l'exposition de l'encre épargne de soudure à un rayonnement actinique et/ou au rayonnement d'un faisceau de particules éventuellement suivi d'un traitement thermique, selon lequel l'encre épargne de soudure est appliquée sur des zones sélectionnées du substrat sous la commande d'un ordinateur par impression à jet d'encre et dans lequel l'encre épargne de soudure comprend les constituants :
A) 30 - 90 parties de monomères à fonction acrylate qui sont des monomères portant une ou plusieurs fonctions acrylate comprenant de 5 - 95% en poids d'un ou plusieurs monomères monofonctionnels;
B) 0,1 - 30 parties de composé organique favorisant l'adhérence aux métaux;
C) 0 - 30 parties d'initiateur;
D) 0 - 10 parties de polymère et/ou de pré-polymère,
E) 0 - 5 parties de colorant;
F) 0 - 5 parties de tensioactif; et
dans lequel toutes les parties sont en poids.

2. Procédé selon la revendication 1 dans lequel la viscosité de l'encre épargne de soudure est de 8 à 20 cP (mPa.s) à 40°C.

3. Procédé selon la revendication 1 ou la revendication 2 dans lequel la masse moléculaire moyenne en poids du monomère à fonction acrylate n'est pas supérieure à 2 000.

4. Procédé selon l'une quelconque des revendications 1 à 3 dans lequel le monomère à fonction acrylate est l'acrylate d'isobornyle, le diacrylate de tripropylèneglycol ou l'éthoxylate triacrylate de triméthylolpropane.

5. Procédé selon l'une quelconque des revendications 1 à 4 dans lequel la quantité de monomère acrylate monofonctionnel est de 70-95% en poids du monomère à fonction acrylate (constituant A)).

6. Procédé selon l'une quelconque des revendications 1 à 5 dans lequel le promoteur d'adhérence est un monomère à fonction acrylate.

7. Procédé selon l'une quelconque des revendications 1 à 6 dans lequel le promoteur d'adhérence contient un groupe de chélation des métaux qui est un acide carboxylique.

8. Procédé selon la revendication 7 dans lequel le promoteur d'adhérence est l'acide (méth)acrylique.

9. Procédé selon l'une quelconque des revendications 1 à 8 dans lequel le promoteur d'adhérence est un tétraacrylate de polypropylèneglycol contenant de l'acide (méth)acrylique.

10. Procédé selon la revendication 9 dans lequel le promoteur d'adhérence a un indice d'acide non supérieur à 120 mg de KOH/g.

11. Procédé selon l'une quelconque des revendications 1 à 10 dans lequel la quantité de promoteur d'adhérence n'est pas supérieure à 15 parties en poids.

12. Procédé selon l'une quelconque des revendications 1 à 11 dans lequel le dispositif électronique est une carte à circuit imprimé.

13. Procédé selon l'une quelconque des revendications 1 à 12 dans lequel l'encre épargne soudure a un indice d'acide non supérieur à 30 mg de KOH/g.

14. Procédé selon l'une quelconque des revendications 1 à 13 dans lequel la quantité d'initiateur n'est pas inférieure à 5 parties.

15. Procédé selon l'une quelconque des revendications 1 à 14 dans lequel le nombre de parties des constituants A) + B) + C) + D) + E) + F) = 100.

16. Encre épargne de soudure non aqueuse qui est essentiellement exempte de solvants organiques qui comprend les constituants:
A) 30 à 90 parties de monomères à fonction acrylate qui sont des monomères portant une ou plusieurs fonctions acrylate comprenant de 5 - 95% en poids d'un ou plusieurs monomères monofonctionnels ;
B) 0,1 à 30 parties de composé organique favorisant l'adhérence aux métaux;
C) 5 à 30 parties d'initiateur ;
D) 0 à 10 parties de polymère et/ou de pré-polymère,
E) 0 à 5 parties de colorant;
F) 0 à 5 parties de tensioactif; et
dans laquelle l'encre a une viscosité non supérieure à 30 cP (mPa.s) à 40°C et toutes les parties sont en poids.

17. Encre épargne de soudure non aqueuse selon la revendication 16 dans laquelle le constituant B) est 0,1 à 30 parties de composé organique favorisant l'adhérence aux métaux contenant un ou plusieurs groupes acide carboxylique et ayant un indice d'acide non supérieur à 120 mg de KOH/g; et l'encre a une viscosité non supérieure à 20 cP (mPa.s) à 40°C.

18. Encre épargne de soudure non aqueuse selon la revendication 16 dans laquelle le constituant B) est 0,1 à 30 parties de composé organique favorisant l'adhérence aux métaux contenant un ou plusieurs groupes acide carboxylique; et l'indice d'acide de l'encre épargne de soudure totale n'est pas supérieur à 30 mg de KOH/g.

19. Encre selon l'une quelconque des revendications 16 à 18 dans laquelle le nombre de parties des constituants A) + B) + C) + D) + E) + F) = 100.

20. Cartouche pour imprimante à jet d'encre comprenant un compartiment et une encre dans laquelle l'encre est présente dans le compartiment et l'encre est une encre épargne de soudure selon l'une quelconque des revendications 16 à 19.

21. Dispositif électronique obtenu par un procédé selon l'une quelconque des revendications 1 à 15.
